# EUROPEAN PATENT APPLICATION

(11) **EP 4 600 674 A1**
(43) Date of publication of application: **13.08.2025**
(21) Application number: 23874077.3
(22) Date of filing: 27.09.2023
(51) Int. Cl.: G01R 31/385, G01R 31/382, H01M 10/44, H02J 7/00, H02M 3/155, H02M 3/28

(54) **CHARGING/DISCHARGING TEST SYSTEM AND METHOD FOR CONTROLLING CHARGING/DISCHARGING TEST SYSTEM**

(30) Priority: 04.10.2022 JP 2022160435
(71) Applicant: Tokyo Seimitsu Co., Ltd., Hachioji-shi, Tokyo 192-8515 (JP)
(72) Inventor: YOKOYAMA, Sempei, Hachioji-shi, Tokyo 192-8515 (JP)
(74) Representative: Grünecker Patent- und Rechtsanwälte PartG mbB
(86) International application number: PCT/JP2023/035123
(87) International publication number: WO 2024/075604

(57) **Abstract**

A charge/discharge test system includes a bidirectional AC/DC converter (12) connected to an AC power supply (an AC power supply (9)), an isolated bidirectional DC/DC converter (22) that has one end connected to a first DC bus (14) and the other end connected to a second DC bus (24), a plurality of non-isolated bidirectional DC/DC converters (26) that have one ends connected to the second DC bus (24) and the other ends connected to charge/discharge targets (batteries (6)) different from each other, and a charge/discharge controlling unit (ET control unit (28)). The charge/discharge controlling unit charges power output from at least one of the charge/discharge targets via the non-isolated bidirectional DC/DC converter (26) into at least one of the charge/discharge targets via the second DC bus (24) and at least one of the non-isolated bidirectional DC/DC converters (26).

## Description

### BACKGROUND OF THE INVENTION

### Field of the Invention

The present invention relates to a charge/discharge test system that performs a charge/discharge test on a charge/discharge target and a control method for the charge/discharge test system.

### Description of the Related Art

In recent years, hybrid cars, plug-in hybrid cars and electric cars have been widely used. Development of inexpensive driving batteries is a key to the distribution of such cars. Unlike batteries for consumers, such as mobile batteries, these batteries typically have capacities that are as large as several kW to several tens of kW. For this reason, significantly large power is required for charging and discharging of the batteries at the time of development and mass production tests of the batteries. The power required for charging and discharging may further increase in the future with advancement in the distribution of cars of these types. In addition, since multiple battery cells are used in combination in the cars of the types, there is a need for a charge/discharge test system capable of testing multiple battery cells in parallel.

A charge/discharge test system includes, for example, a plurality of power supply devices, each including a bidirectional AC/DC (alternating current/direct current) converter and at least one bidirectional DC/DC converter (see Patent Literature 1, for example). One end of the bidirectional AC/DC converter of each power supply device is connected to an AC power supply via an AC bus, and the other end of the bidirectional AC/DC converter of the power supply device is connected to one end of the at least one bidirectional DC/DC converter via a DC bus. Further, a battery (charge/discharge target) that is an object of charge/discharge test is connected to the other end of the bidirectional DC/DC converter of each power supply device.

Each bidirectional AC/DC converter converts AC power input from the AC power supply via the AC bus into DC power and outputs the DC power to the bidirectional DC/DC converter via the DC bus. Each bidirectional DC/DC converter controls charging and discharging of the battery subjected to the charge/discharge test. In a case where a certain one of the plurality of batteries is discharged in the charge/discharge test, power discharged from the battery passes from the power supply device (the bidirectional DC/DC converter, the DC bus, and the bidirectional AC/DC converter) through the AC bus and at least another one of the power supply devices, and is used to charge at least another one of the batteries. Alternatively, the power discharged from the battery is regeneratively returned from the power supply device to the AC power supply through the AC bus.

### Citation List

### Patent Literature(s)

Patent Literature 1: Japanese Patent Application Laid-Open No. 2012-154793

### SUMMARY OF THE INVENTION

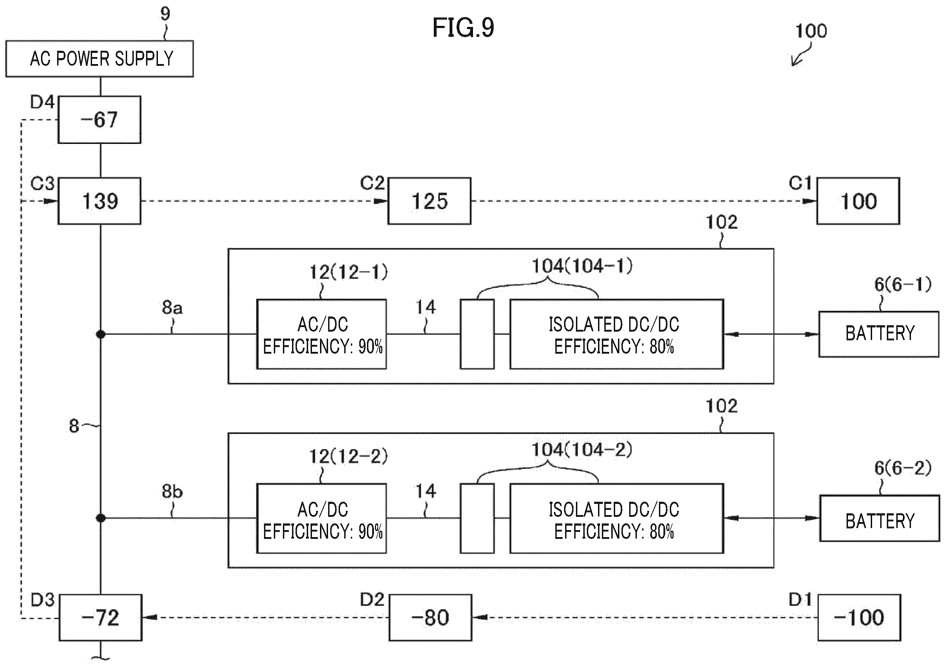

In passing power discharged from a battery in a charge/discharge test from a power supply device through an AC bus and using the power to charge a battery connected to at least another one power supply device as described in Patent Literature 1, DC/DC conversion, DC/AC conversion, AC/DC conversion, and DC/DC conversion need to be performed in turn, resulting in increase in the number of times of power conversions (see Figure 9). This increases an amount of power loss that is a part of power discharged from a battery and consumed by the power conversion and the like, before the power is used for charging another battery. As a result, power utilization efficiency is deteriorated in the charge/discharge test system.

In light of such a power loss, it is required to increase the power supplied from the AC power supply at the time of a charge/discharge test, and upsize each converter in response to the power increase. This results in a problem of increase in size and cost of the charge/discharge test system (see Figure 9).

The present invention has been made in view of the above-described circumstances, and aims to provide a charge/discharge test system and a control method for the charge/discharge test system capable of implementing enhancement of power utilization efficiency, a size reduction, and a cost reduction.

For achieving the object of the present invention, a charge/discharge test system which performs a charge/discharge test on a plurality of charge/discharge targets, the charge/discharge test system includes: a bidirectional AC/DC converter that has one end connected to an AC power supply via an AC bus and the other end connected to a first DC bus; an isolated bidirectional DC/DC converter that has one end connected to the bidirectional AC/DC converter via the first DC bus and the other end connected to a second DC bus; a plurality of non-isolated bidirectional DC/DC converters that respectively have one ends connected to the isolated bidirectional DC/DC converter via the second DC bus and the other ends connected to charge/discharge targets different from each other; and a charge/discharge controlling unit configured to control the bidirectional AC/DC converter, the isolated bidirectional DC/DC converter, and the non-isolated bidirectional DC/DC converters, to control charging and discharging of the charge/discharge targets respectively connected to the non-isolated bidirectional DC/DC converters, wherein the charge/discharge controlling unit charges power output from at least one charge/discharge target to be discharged among the charge/discharge targets via the non-isolated bidirectional DC/DC converter, into at least chargeable one of the charge/discharge targets via the second DC bus and at least one of the non-isolated bidirectional DC/DC converters.

According to the charge/discharge test system, it is possible to perform energy sharing (ES) between charge/discharge targets respectively connected to non-isolated bidirectional DC/DC converters different from each other via the second DC bus 24.

In the charge/discharge test system according to another aspect of the present invention, in a case where discharge power that is power discharged from all charge/discharge targets to be discharged is in surplus over necessary charge power that is power necessary to charge all charge/discharge targets to be charged, the charge/discharge controlling unit regeneratively returns surplus power corresponding to a surplus amount of the discharge power from at least one of the non-isolated bidirectional DC/DC converters to the AC power supply via the second DC bus, the isolated bidirectional DC/DC converter, the first DC bus, the bidirectional AC/DC converter and the AC bus. This minimizes an amount of power to be regeneratively returned to the AC power supply, thereby enhancing power utilization efficiency of the charge/discharge test system.

In the charge/discharge test system according to another aspect of the present invention, in a case where discharge power that is power discharged from all charge/discharge targets to be discharged is in shortage below necessary charge power that is power necessary to charge all charge/discharge targets to be charged, the charge/discharge controlling unit charges supplementary power that supplements a shortage amount of the discharge power from the AC power supply into at least one of the charge/discharge targets via the AC bus, the bidirectional AC/DC converter, the first DC bus, the isolated bidirectional DC/DC converter, the second DC bus and at least one of the non-isolated bidirectional DC/DC converters. This minimizes an amount of power to be supplemented from the AC power supply, thereby enhancing power utilization efficiency of the charge/discharge test system.

The charge/discharge test system according to another aspect of the present invention includes a power pool which is connected to the second DC bus, and configured to be charged and discharged under control by the charge/discharge controlling unit, and in a case where discharge power that is power discharged from all charge/discharge targets to be discharge is in surplus over necessary charge power that is power necessary to charge all charge/discharge targets to be charged, the charge/discharge controlling unit charges surplus power corresponding to a surplus amount of the discharge power from at least one of the non-isolated bidirectional DC/DC converters into the power pool via the second DC bus. This minimizes an amount of power to be regeneratively returned to the AC power supply, thereby enhancing power utilization efficiency of the charge/discharge test system.

In the charge/discharge test system according to another aspect of the present invention, in a case where there is an excess of the surplus power over a chargeable capacity of the power pool, the charge/discharge controlling unit regeneratively returns power corresponding to an excess amount of the surplus power from the second DC bus to the AC power supply via the isolated bidirectional DC/DC converter, the first DC bus, the bidirectional AC/DC converter and the AC bus. This minimizes an amount of power to be regeneratively returned to the AC power supply, thereby enhancing power utilization efficiency of the charge/discharge test system.

In the charge/discharge test system according to another aspect of the present invention, a plurality of power supply devices respectively including the isolated bidirectional DC/DC converter, the second DC bus, the power pool and the plurality of non-isolated bidirectional DC/DC converters, are connected to the bidirectional AC/DC converter via the first DC bus, and in a case where there is an excess of the surplus power over a chargeable capacity of the power pool in at least one of the power supply devices, the charge/discharge controlling unit outputs power corresponding to an excess amount of the surplus power in the at least one of the power supply devices, to at least another one of the power supply devices that is capable of receiving input of power, via the first DC bus. This minimizes an amount of power to be regeneratively returned to the AC power supply, thereby enhancing power utilization efficiency of the charge/discharge test system.

The charge/discharge test system according to another aspect of the present invention includes a power pool which is connected to the second DC bus, and configured to be charged and discharged under control by the charge/discharge controlling unit, and in a case where discharge power that is power discharged from all charge/discharge targets to be discharged is in shortage below necessary charge power that is power necessary to charge all charge/discharge targets to be charged, the charge/discharge controlling unit charges supplementary power that supplements a shortage amount of the discharge power from the power pool into at least one of the charge/discharge targets via the second DC bus and at least one of the non-isolated bidirectional DC/DC converters. This minimizes an amount of power to be supplemented from the AC power supply, thereby enhancing power utilization efficiency of the charge/discharge test system.

In the charge/discharge test system according to another aspect of the present invention, in a case where a dischargeable capacity of the power pool is in shortage below the shortage amount of the discharge power, the charge/discharge controlling unit charges power that supplements a shortage amount of the dischargeable capacity from the AC power supply into at least one of the charge/discharge targets via the AC bus, the bidirectional AC/DC converter, the first DC bus, the isolated bidirectional DC/DC converter, the second DC bus, and at least one of the non-isolated bidirectional DC/DC converters. This minimizes an amount of power to be supplemented from the AC power supply, thereby enhancing power utilization efficiency of the charge/discharge test system.

In the charge/discharge test system according to another aspect of the present invention, a plurality of power supply devices respectively including the isolated bidirectional DC/DC converter, the second DC bus, the power pool and the plurality of non-isolated bidirectional DC/DC converters, are connected to the bidirectional AC/DC converter via the first DC bus, and in a case where the dischargeable capacity of the power pool is in shortage below the shortage amount of the discharge power in at least one of the power supply devices, the charge/discharge controlling unit outputs power from at least one of the power supply devices that is capable of outputting power to the at least one of the power supply devices in which the dischargeable capacity is in shortage, via the first DC bus.

In the charge/discharge test system according to another aspect of the present invention, a plurality of power supply devices respectively including the isolated bidirectional DC/DC converter, the second DC bus and the plurality of non-isolated bidirectional DC/DC converters, are connected to the bidirectional AC/DC converter via the first DC bus, and in a case where power necessary to charge a charge/discharge target is in shortage in at least one of the power supply devices, and at least another one of the power supply devices is capable of power supply to other the power supply devices, the charge/discharge controlling unit executes power supply from the at least another one of the power supply devices capable of power supply to the at least one of the power supply devices in which the power necessary to charge the charge/discharge target is in shortage, via the first DC bus. This minimizes an amount of power to be supplemented from the AC power supply, thereby enhancing power utilization efficiency of the charge/discharge test system.

In the charge/discharge test system according to another aspect of the present invention, the charge/discharge controlling unit synchronizes timings for the charge/discharge test between the power supply devices different from each other. Thus, power may be supplied from a power supply device with power surplus to a power supply device with power shortage.

In the charge/discharge test system according to another aspect of the present invention, the charge/discharge controlling unit calculates the necessary charge power based on a result of correction which increases power necessary to charge the all charge/discharge targets to be charged by an amount of power consumed by all non-isolated bidirectional DC/DC converters corresponding to the all of charge/discharge targets to be charged, and the charge/discharge controlling unit calculates the discharge power based on a result of correction which reduces power discharged from the all charge/discharge targets to be discharged by an amount of power consumed by all non-isolated bidirectional DC/DC converters corresponding to the all charge/discharge targets to be discharged. This allows execution of ES with reflecting power consumed by the non-isolated bidirectional DC/DC converters.

In the charge/discharge test system according to another aspect of the present invention, the plurality of non-isolated bidirectional DC/DC converters respectively include: at least one converter under test, connected to a test charge/discharge target that is a charge/discharge target subjected to the charge/discharge test; and at least one surplus converter connected to an auxiliary charge/discharge target that is another charge/discharge target other than the test charge/discharge target. This allows enhancement of the power utilization efficiency of the charge/discharge test system. In addition, the use of the auxiliary charge/discharge target achieves a reduction in the cost of the charge/discharge test system.

In the charge/discharge test system according to another aspect of the present invention, the charge/discharge controlling unit synchronizes a timing for discharging power from at least one of the charge/discharge targets and a timing for charging power into at least one of the charge/discharge targets. This allows execution of ES.

For achieving the object of the present invention, a control method for a charge/discharge test system, the system including a bidirectional AC/DC converter that has one end connected to an AC power supply via an AC bus and the other end connected to a first DC bus, an isolated bidirectional DC/DC converter that has one end connected to the bidirectional AC/DC converter via the first DC bus and the other end connected to a second DC bus, and a plurality of non-isolated bidirectional DC/DC converters that respectively have one ends connected to the isolated bidirectional DC/DC converter via the second DC bus and the other ends connected to charge/discharge targets different from each other, wherein the bidirectional AC/DC converter, the isolated bidirectional DC/DC converter and the non-isolated bidirectional DC/DC converters, are controlled to control charging and discharging of the charge/discharge targets respectively connected to the non-isolated bidirectional DC/DC converters, the control method charges power output from at least one of the charge/discharge targets to be discharged via the non-isolated bidirectional DC/DC converter, into at least chargeable one of the charge/discharge targets via the second DC bus and at least one of the non-isolated bidirectional DC/DC converters.

The present invention may implement enhancement of power utilization efficiency, a size reduction, and a cost reduction.

### BRIEF DESCRIPTION OF THE DRAWINGS

Figure 1 is a schematic diagram of a charge/discharge test system according to a first embodiment;
Figure 2 is a block diagram of a power supply device according to the first embodiment;
Figure 3 is an explanatory chart showing an example of charge/discharge patterns for two batteries;
Figure 4 are graphs in which reference character 4A denotes a graph showing an example of a battery charge pattern, and reference character 4B denotes a graph showing an example of a battery discharge pattern, and reference character 4C denotes a differential pattern corresponding to a difference between the charge pattern and the discharge pattern;
Figure 5 is an explanatory diagram for explaining charge/discharge control on two batteries in a case where there is no shortage nor surplus of the discharge power with respect to necessary charge power;
Figure 6 is an explanatory diagram for explaining charge/discharge control on the two batteries 6 and regenerative return of surplus power in a case where there is a surplus of discharge power over the necessary charge power;
Figure 7 is an explanatory diagram for explaining charge/discharge control on the two batteries 6 and supply of supplementary power in a case where there is a shortage of discharge power below necessary charge power;
Figure 8 is a flowchart showing a control method for the charge/discharge test system according to the first embodiment, especially a flow of a charge/discharge test on the two batteries 6 by the charge/discharge test system 10;
Figure 9 is an explanatory diagram for explaining power utilization efficiency of a charge/discharge test system according to a comparative example;
Figure 10 is an explanatory diagram for explaining power utilization efficiency of the charge/discharge test system according to the first embodiment;
Figure 11 is an explanatory chart for explaining calculation of a differential pattern by an ET control unit according to a second embodiment;
Figure 12 is a block diagram of a charge/discharge test system according to a third embodiment;
Figure 13 is an explanatory diagram for explaining power pool-based ES and regenerative return of surplus power to an AC power supply in a case where there is a surplus of discharge power over the necessary charge power;
Figure 14 is an explanatory diagram for explaining power pool-based ES and supplementary power supply from the AC power supply in a case where there is a shortage of the discharge power below the necessary charge power;
Figure 15 is a flowchart showing a flow of a charge/discharge test on two batteries by the charge/discharge test system according to the third embodiment;
Figure 16 is a block diagram of a charge/discharge test system according to a fourth embodiment;
Figure 17 is a block diagram of a charge/discharge test system according to a fifth embodiment;
Figure 18 is a block diagram of a charge/discharge test system according to a sixth embodiment;
Figure 19 is an explanatory diagram for explaining inter-power supply device ES and regenerative return of surplus power to an AC power supply; and
Figure 20 is an explanatory diagram for explaining inter-power supply device ES and supplementary power supply from the AC power supply.

### DESCRIPTION OF THE EMBODIMENTS

### [First Embodiment]

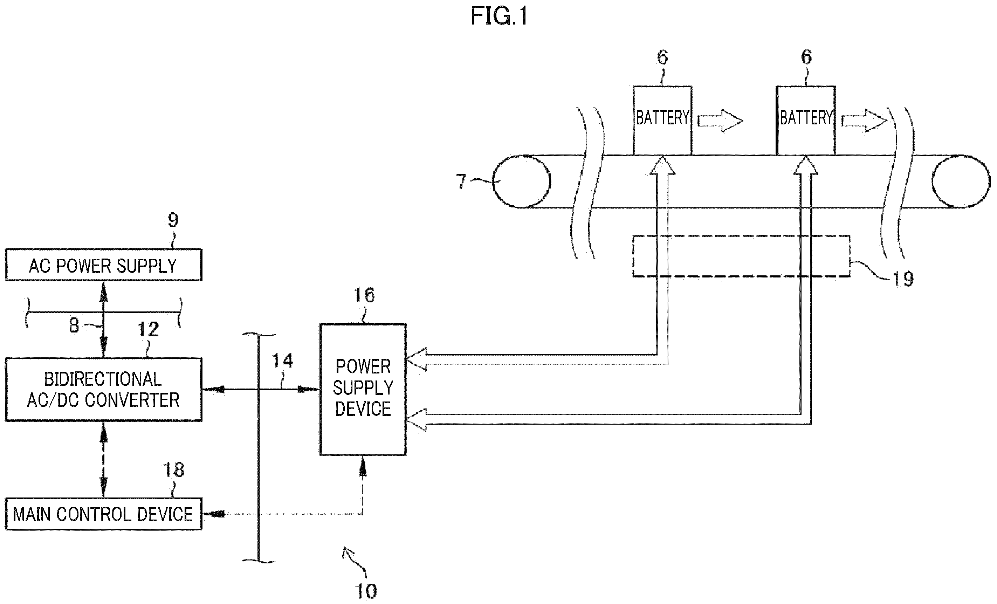

Figure 1 is a schematic diagram of a charge/discharge test system 10 according to a first embodiment. As shown in Figure 1, the charge/discharge test system 10 is provided on a production line 7 for a battery 6. The charge/discharge test system 10 may execute charge/discharge tests on batteries 6 on the production line 7 in parallel. Note that each battery 6 corresponds to a charge/discharge target of the present invention and is, for example, one of various types of publicly known secondary batteries, such as a lithium ion battery, a nickel hydrogen battery, and an all-solid-state battery, (and devices including a large-capacity capacitor, such as an electric double layer capacitor, and capable of accumulating power).

The charge/discharge test system 10 includes a bidirectional AC/DC converter 12, a first DC bus 14, a power supply device 16, and a main control device 18.

One end of the bidirectional AC/DC converter 12 is connected to an AC bus 8 and is further connected to an AC power supply 9 (alternating-current power supply) via the AC bus 8. The other end, which is on the opposite side from the one end, of the bidirectional AC/DC converter 12 is connected to the first DC bus 14 and is further connected to the power supply device 16 via the first DC bus 14.

In supplying power to the power supply device 16, the bidirectional AC/DC converter 12 converts AC power (or AC current) input from the AC power supply 9 via the AC bus 8 into DC power (DC current) and outputs the DC power to the power supply device 16 via the first DC bus 14. In addition, the bidirectional AC/DC converter 12 converts DC power (or DC current) input from the power supply device 16 via the first DC bus 14 into AC power (or AC current), and returns or outputs (hereinafter simply referred to as "regeneratively returns") the AC power to the AC power supply 9 via the AC bus 8.

One end of the power supply device 16 is connected to the first DC bus 14 and is further connected to the bidirectional AC/DC converter 12 via the first DC bus 14. The other end, which is on the opposite side from the one end, of the power supply device 16 is connected to two cables (not shown) and is further connected to a jointing part 19 via the two cables.

The jointing part 19 electrically connects a plurality of cables and a plurality of (e.g., two) batteries 6 that are conveyed to predetermined test positions on the production line 7. With this connection, the other end of the power supply device 16 electrically connects with the two batteries 6 on the production line 7 via the cables and the jointing part 19. As a result, charge/discharge tests on the two batteries 6 may be executed. Note that it is also possible to convey a plurality of batteries 6 on the production line 7 to test positions in turn two by two, and execute a charge/discharge test.

The power supply device 16 executes charging and discharging (a charge/discharge test) on the two batteries 6 electrically connected to the power supply device 16 in accordance with respective charge/discharge patterns for two batteries 6 that are set by the main control device 18 (to be described later). In executing a charge/discharge test on the two batteries 6, the power supply device 16 performs energy sharing (also referred to as power sharing) that uses power discharged from one of the two batteries 6 to charge the other of the two batteries 6. Energy sharing (ES) will be abbreviated as "ES" below as appropriate.

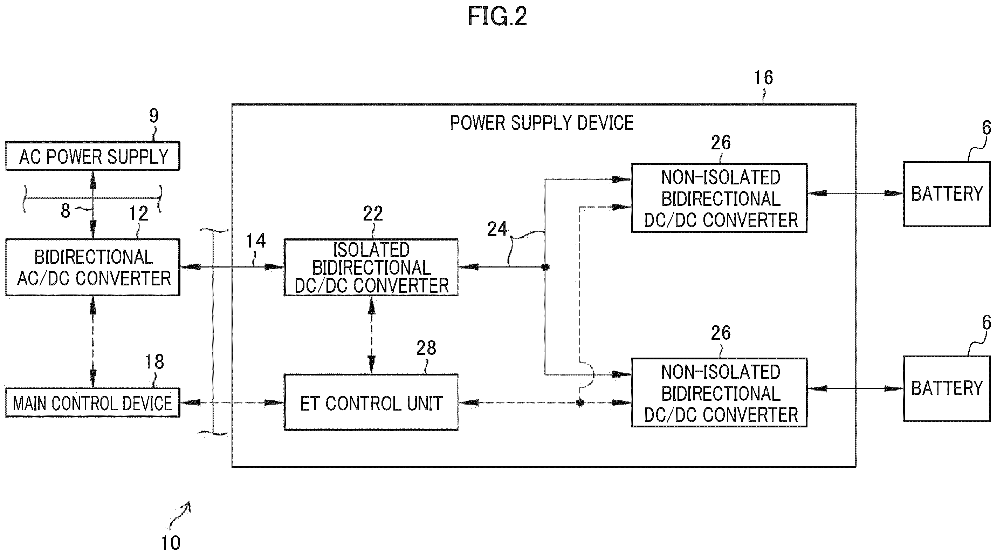

The main control device 18 constitutes a charge/discharge controlling unit of the present invention, together with an ET control unit 28 (see Figure 2) of the power supply device 16 (to be described later). For example, a publicly known control device, such as a programmable logic controller (PLC), may be used as the main control device 18. The main control device 18 is electrically connected to the bidirectional AC/DC converter 12 and the power supply device 16. The main control device 18 controls the bidirectional AC/DC converter 12 and the power supply device 16 to perform a charge/discharge test on the two batteries 6 in accordance with respective charge/discharge patterns for two batteries 6 that are input in advance by an operator.

The charge/discharge pattern is defined depending on a type of the battery 6 and a test purpose of a charge/discharge test. In the present embodiment, the types and test purposes of the two batteries 6 are the same each other, and the respective charge/discharge patterns set for the two batteries 6 are the same.

Here, the present embodiment explains a case where the charge/discharge patterns for the two batteries 6 can be directly input to the main control device 18, for an example. However, a setting unit (not shown) for charge/discharge pattern setting may be connected to the main control device 18. A PC (Personal Computer), a terminal other than a PC such as a mobile terminal, a tablet terminal, or the like, may be used for the setting unit, as examples.

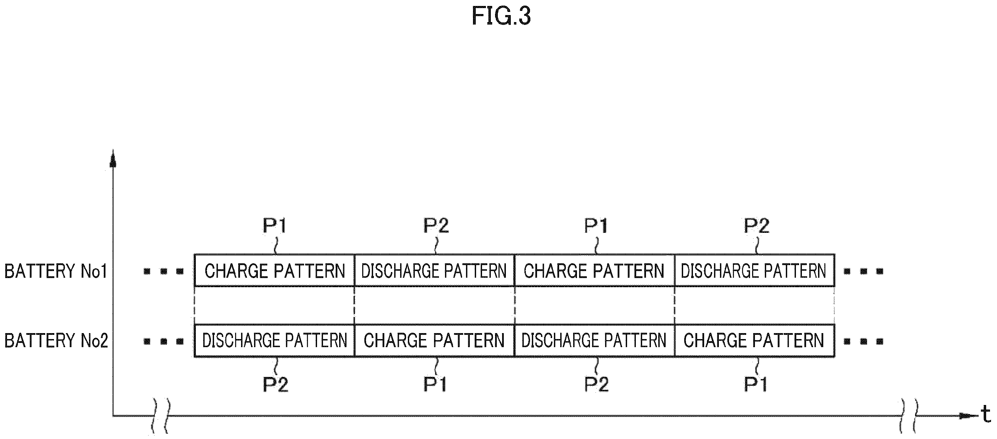

Figure 2 is a block diagram of the power supply device 16 according to the first embodiment. Note that, for brevity of illustration, the production line 7 and the jointing part 19 are not shown in Figure 2 (the same applies to Figure 3 and the subsequent figures). As shown in Figure 2, the power supply device 16 includes an isolated bidirectional DC/DC converter 22, a second DC bus 24, two non-isolated bidirectional DC/DC converters 26, and the ET (Energy Testing System) control unit 28.

One end of the isolated bidirectional DC/DC converter 22 is connected to the first DC bus 14 and is further connected to the bidirectional AC/DC converter 12 via the first DC bus 14. The other end, which is on the opposite side from the one end, of the isolated bidirectional DC/DC converter 22 is connected to the second DC bus 24 and is further connected to respective one ends of the two non-isolated bidirectional DC/DC converters 26 via the second DC bus 24. The respective batteries 6 are connected to the other ends, which is on the opposite side from the one ends, of the two non-isolated bidirectional DC/DC converters 26 via the already-described cables and the jointing part 19 (see Figure 1).

In the isolated bidirectional DC/DC converter 22, the one end and the other end are electrically isolated from each other. The isolated bidirectional DC/DC converter 22 transfers power between the one end and the other end, using a coupled inductor provided between the one end and the other end. The isolated bidirectional DC/DC converter 22 decreases a high DC voltage input from the first DC bus 14 and outputs the decreased voltage to each non-isolated bidirectional DC/DC converters 26 connected to the batteries 6 to be charged, via the second DC bus 24. In addition, the isolated bidirectional DC/DC converter 22 increases a DC voltage input from each non-isolated bidirectional DC/DC converter 26 via the second DC bus 24, and then outputs the increased DC voltage to the bidirectional AC/DC converter 12 via the first DC bus 14.

In each non-isolated bidirectional DC/DC converter 26, the one end and the other end are not electrically isolated from each other, unlike in the isolated bidirectional DC/DC converter 22. The non-isolated bidirectional DC/DC converter 26 uses a transformer. For this reason, the non-isolated bidirectional DC/DC converter 26 is smaller in size and lower in cost than the isolated bidirectional DC/DC converter 22.

In charging each battery 6, the non-isolated bidirectional DC/DC converter 26 decreases a DC voltage input from the isolated bidirectional DC/DC converter 22 or the other non-isolated bidirectional DC/DC converter 26 via the second DC bus 24 to be a low DC voltage corresponding to the battery 6, and then charges the battery 6. In discharging the battery 6, the non-isolated bidirectional DC/DC converter 26 increases a low DC voltage output from the battery 6 and then outputs the increased DC voltage to the isolated bidirectional DC/DC converter 22 or the other non-isolated bidirectional DC/DC converter 26 via the second DC bus 24.

Although not shown, each non-isolated bidirectional DC/DC converter 26 is provided with a detection unit that continuously detects: a charge amount in the battery 6 connected to the non-isolated bidirectional DC/DC converter 26; a current power consumption used to charge the battery 6 to be charged; and a current power discharge amount discharged from the battery 6 to be discharged. The charge amount of the battery 6, and the power consumption or the power discharge amount, which are detected by the detection unit, are sequentially output to the main control device 18 and the ET control unit 28.

The ET control unit 28 is, for example, a publicly known control device, such as a PLC. The ET control unit 28 functions as the charge/discharge controlling unit of the present invention, together with the main control device 18. The ET control unit 28 controls the isolated bidirectional DC/DC converter 22 and the two non-isolated bidirectional DC/DC converters 26 in accordance with the charge/discharge patterns for the two batteries 6 input from the main control device 18, thereby controlling charging and discharging of the two batteries 6 in performing the charge/discharge test.

The ET control unit 28 executes ES that uses power discharged from one of the two batteries 6 to charge the other of the two batteries 6, in executing charge/discharge control on the two batteries 6. In the ES, power discharged from one of the two batteries 6 is charged into the other of the two batteries 6 via one of the two non-isolated bidirectional DC/DC converters 26, the second DC bus 24, and the other of the two non-isolated bidirectional DC/DC converters 26. As described above, in the present embodiment, a plurality of (e.g., two) non-isolated bidirectional DC/DC converters 26 are connected to the isolated bidirectional DC/DC converter 22 via the second DC bus 24, thereby allowing execution of ES via the second DC bus 24 and the two non-isolated bidirectional DC/DC converters 26.

Figure 3 is an explanatory chart showing an example of charge/discharge patterns for the two batteries 6. Note that the horizontal axis in Figure 3 represents time (t). As shown in Figure 3, in the charge/discharge test on the two batteries 6 (batteries No1 and No2 in Figure 3), charging with a charge pattern P1 and discharging with a discharge pattern P2 are repeatedly executed multiple times (the number of times may be one) for each battery 6. Note that it is not required to use the same charge pattern P1 and the same discharge pattern P2 in each time. The charge pattern P1 and the discharge pattern P2 may be appropriately changed.

The ET control unit 28 synchronize a charge timing for charging one of the two batteries 6 in accordance with the charge pattern P1, with a discharge timing for discharging the other of the two batteries 6 in accordance with the discharge pattern P2 in order to execute the ES described above. That is, in charging one of the two batteries 6 in accordance with the charge pattern P1, the ET control unit 28 discharges the other of the two batteries 6 in accordance with the discharge pattern P2. In addition, in charging the other of the two batteries 6 in accordance with the charge pattern P1, the ET control unit 28 discharges the one of the two batteries 6 in accordance with the discharge pattern P2.

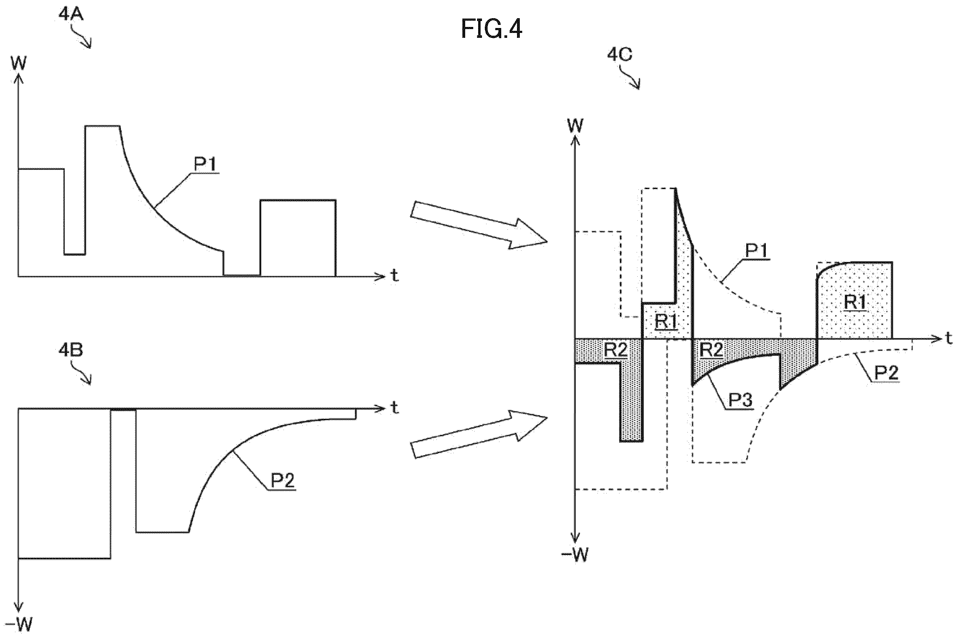

Reference character 4A in Figure 4 denotes a graph showing an example of the charge pattern P1 for the battery 6, reference character 4B denotes a graph showing an example of the discharge pattern P2 for the battery 6, and reference character 4C denotes a graph showing a differential pattern P3 corresponding to a difference between the charge pattern P1 and the discharge pattern P2. Note that a positive value (W) on the vertical axis of each graph in Figure 4 indicates a magnitude of power (current) charged into the battery 6 and that a negative value (-W) on the vertical axis of each graph indicates a magnitude of power (current) discharged from the battery 6. The horizontal axis of each graph in Figure 4 represents time (t).

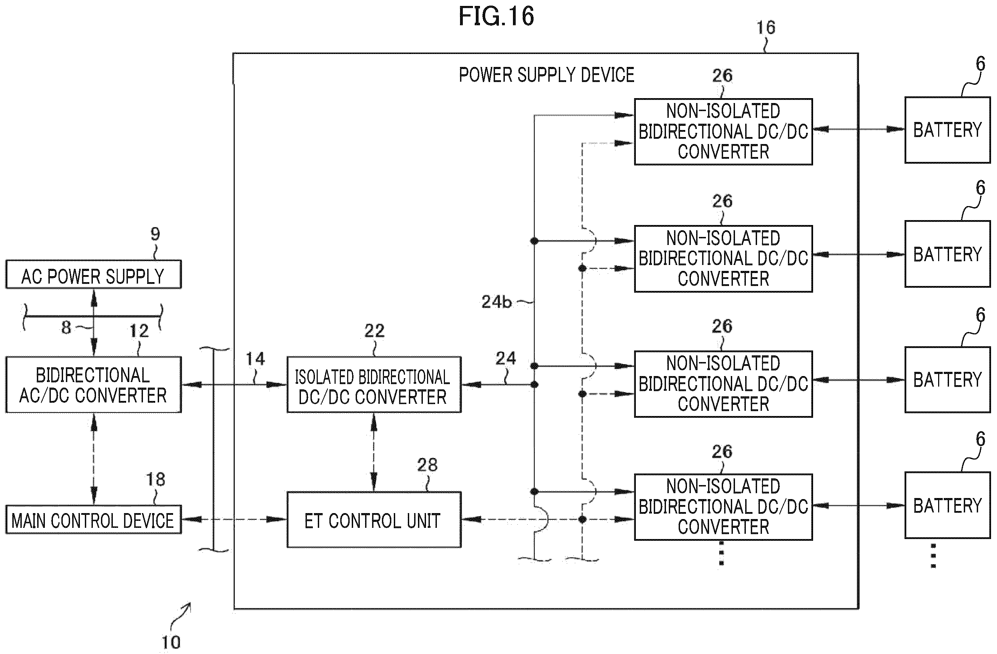

As indicated by reference characters 4A and 4B in Figure 4, the charge pattern P1 indicates a temporal change in necessary charge power that is power necessary to charge all batteries 6 (one battery 6 here) to be charged, and the discharge pattern P2 indicates a temporal change in discharge power that is power discharged from all batteries 6, e.g., one battery 6, to be discharged. Note that, if the power supply device 16 controls charging and discharging of three or more batteries 6 as shown in Figure 16 (to be described later), a combined charge pattern obtained by combining the charge patterns P1 for all of two or more batteries 6 to be charged indicates a temporal change in necessary charge power. A combined discharge pattern obtained by combining the discharge patterns P2 for all of two or more batteries 6 to be discharged indicates a temporal change in discharge power.

As indicated by reference character 4C in Figure 4, the ET control unit 28 calculates the differential pattern P3 corresponding to the difference between the charge pattern P1 and the discharge pattern P2 to synchronize the charge timing of one of the two batteries 6 with the discharge timing of the other of the two batteries 6, as shown in Figure 3. The ET control unit 28 repeatedly executes a determination process (hereinafter simply referred to as the "determination process") of determining whether or not there is a shortage (see reference character R1) or a surplus (reference character R2) of current discharge power with respect to current necessary charge power, based on a calculation result of the differential pattern P3. The ET control unit 28 controls charging and discharging of the two batteries 6 such that ES is preferentially executed, based on a result of the determination process.

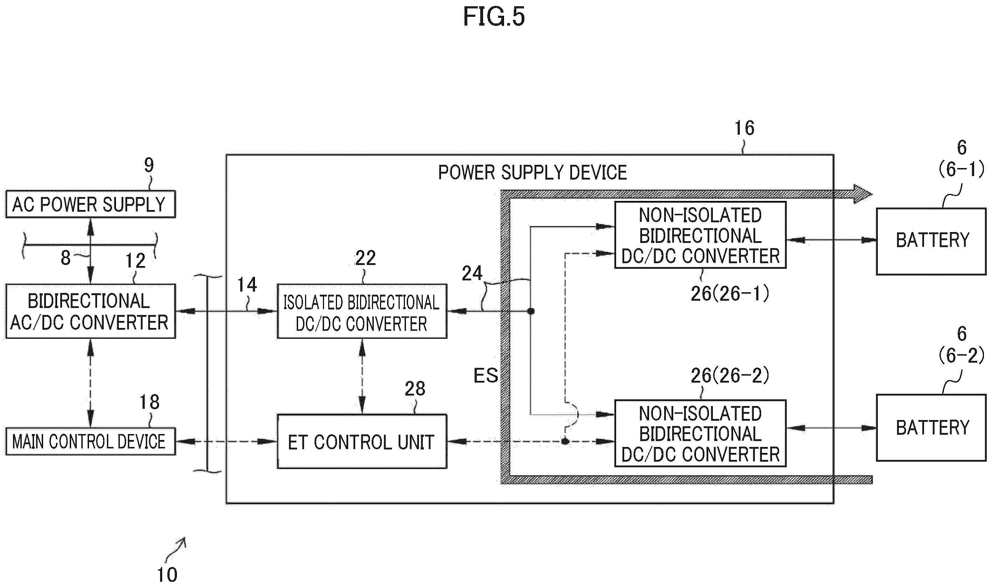

Figure 5 is an explanatory diagram for explaining charge/discharge control on the two batteries 6 in a case where there is no shortage nor surplus of the discharge power (the discharge power is not in shortage nor in surplus) with respect to the necessary charge power. Note that Figure 5 shows an ideal state based on the assumption that power consumed by power conversion in the non-isolated bidirectional DC/DC converters 26 is zero.

The battery 6 to be charged in accordance with the charge pattern P1 will be referred to as a "battery 6-1" as appropriate, and the battery 6 to be discharged in accordance with the discharge pattern P2 will be referred to as a "battery 6-2" as appropriate. The non-isolated bidirectional DC/DC converter 26 that is electrically connected to the battery 6-1 will be referred to as a "non-isolated bidirectional DC/DC converter 26-1" as appropriate, and the non-isolated bidirectional DC/DC converter 26 that is electrically connected to the battery 6-2 will be referred to as a "non-isolated bidirectional DC/DC converter 26-2" as appropriate.

As shown in Figure 5, when a result of the determination process indicates that there is no shortage nor surplus of the discharge power with respect to the necessary charge power, the ET control unit 28 controls the two non-isolated bidirectional DC/DC converters 26 to execute only ES. With this operation, power output from the battery 6-2 via the non-isolated bidirectional DC/DC converter 26-2 is used to charge the battery 6-1 via the second DC bus 24 and the non-isolated bidirectional DC/DC converter 26-1.

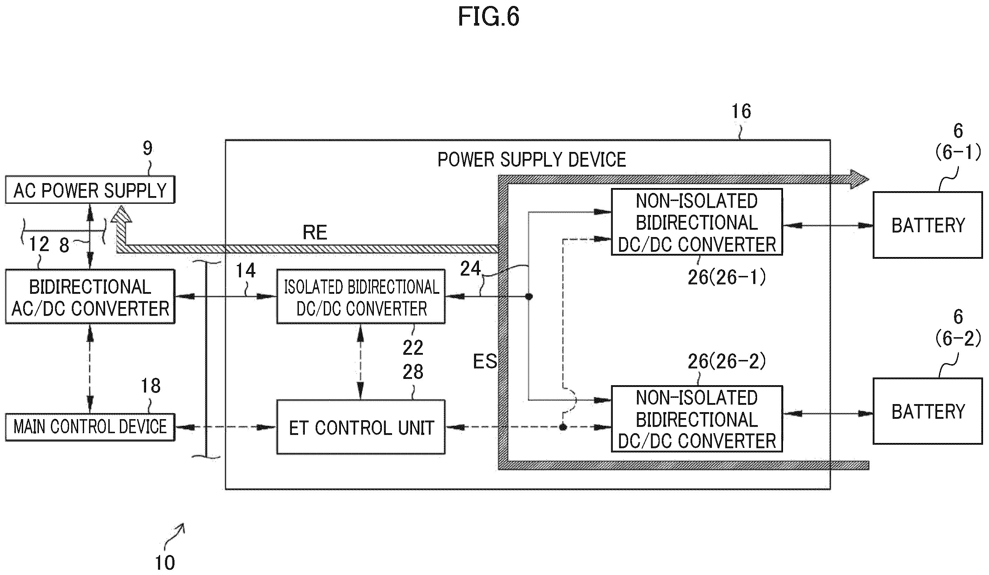

Figure 6 is an explanatory diagram for explaining charge/discharge control on the two batteries 6 and regenerative return of surplus power in a case where there is a surplus of the discharge power over the necessary charge power. As shown in Figure 6, when a result of the determination process indicates that there is a surplus of discharge power over necessary charge power, the ET control unit 28 controls the isolated bidirectional DC/DC converter 22 and the non-isolated bidirectional DC/DC converters 26, to execute both ES and output of surplus power to the bidirectional AC/DC converter 12.

Specifically, the ET control unit 28 controls the two non-isolated bidirectional DC/DC converters 26 to execute ES such that a part of the discharge power is used to charge the battery 6-1 by an amount corresponding to the necessary charge power. The ET control unit 28 controls the non-isolated bidirectional DC/DC converter 26-2 and the isolated bidirectional DC/DC converter 22 such that the surplus power corresponding to a surplus (rest) of the discharge power over the necessary charge power, is output to the bidirectional AC/DC converter 12. With this operation, the surplus power is input from the battery 6-2 to the bidirectional AC/DC converter 12 via the non-isolated bidirectional DC/DC converter 26-2, the second DC bus 24, the isolated bidirectional DC/DC converter 22, and the first DC bus 14.

The main control device 18 actuates the bidirectional AC/DC converter 12 when the determination process by the ET control unit 28 indicates that there is a surplus of discharge power. The bidirectional AC/DC converter 12 converts the surplus power (DC power) input from the power supply device 16 via the first DC bus 14 into AC power and then regeneratively returns the AC power to the AC power supply 9 via the AC bus 8 (see reference character RE).

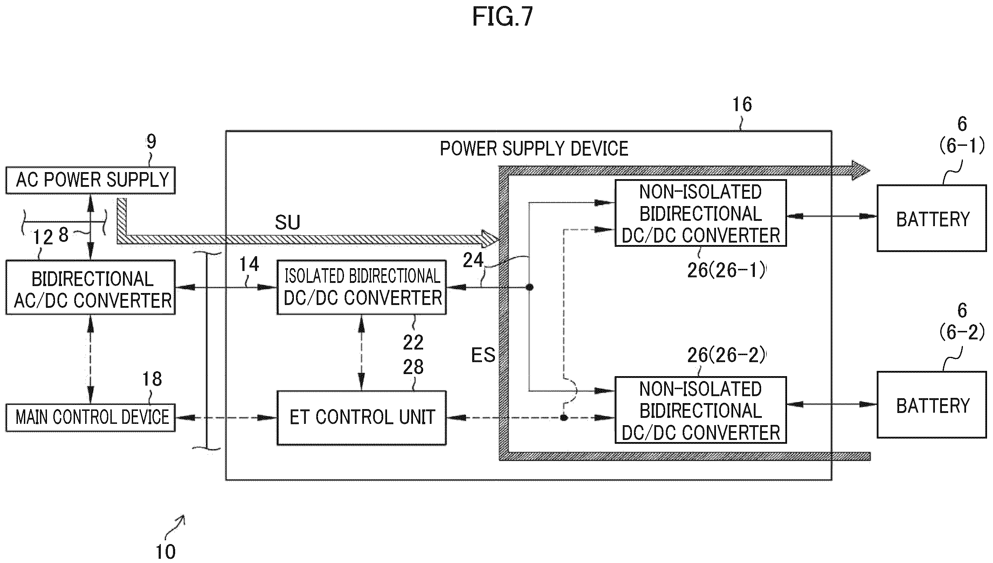

Figure 7 is an explanatory diagram for explaining charge/discharge control on the two batteries 6 and supply of supplementary power in a case where there is a shortage of discharge power below the necessary charge power. As shown in Figure 7, when the determination process by the ET control unit 28 indicates that there is a shortage of discharge power, the main control device 18 actuates the bidirectional AC/DC converter 12. When supplementary power (AC power) is supplied in order to supplement a shortage amount of the discharge power from the AC power supply 9 via the AC bus 8, the bidirectional AC/DC converter 12 converts the supplementary power into DC power and then outputs the DC power to the isolated bidirectional DC/DC converter 22 via the first DC bus 14 (see reference character SU). Note that the supplementary power includes power to be consumed by power conversion in each of the bidirectional AC/DC converter 12, the isolated bidirectional DC/DC converter 22 and the non-isolated bidirectional DC/DC converter 26-2, in addition to the shortage amount of the discharge power.

When a result of the determination process indicates that there is a shortage of the discharge power below necessary charge power, the ET control unit 28 controls the isolated bidirectional DC/DC converter 22 and the non-isolated bidirectional DC/DC converters 26 to execute both ES and charging of the battery 6-1 using the supplementary power.

Specifically, the ET control unit 28 controls the non-isolated bidirectional DC/DC converters 26 to execute ES that charges the whole of discharge power discharged from the battery 6-2 into the battery 6-1 via the non-isolated bidirectional DC/DC converter 26-2, the second DC bus 24, and the non-isolated bidirectional DC/DC converter 26-1.

The ET control unit 28 also controls the isolated bidirectional DC/DC converter 22 and the non-isolated bidirectional DC/DC converter 26-1 to supply the supplementary power from the isolated bidirectional DC/DC converter 22 to the second DC bus 24 (see reference character SU), thereby charging the supplementary power into the battery 6-1 via the non-isolated bidirectional DC/DC converter 26-1. Hereinafter, feeding of supplementary power for charging the battery 6-1 from the AC power supply 9 as shown in Figure 7 will be referred to as "supplementary power supply."

### [Action of Charge/Discharge Test System according to First Embodiment]

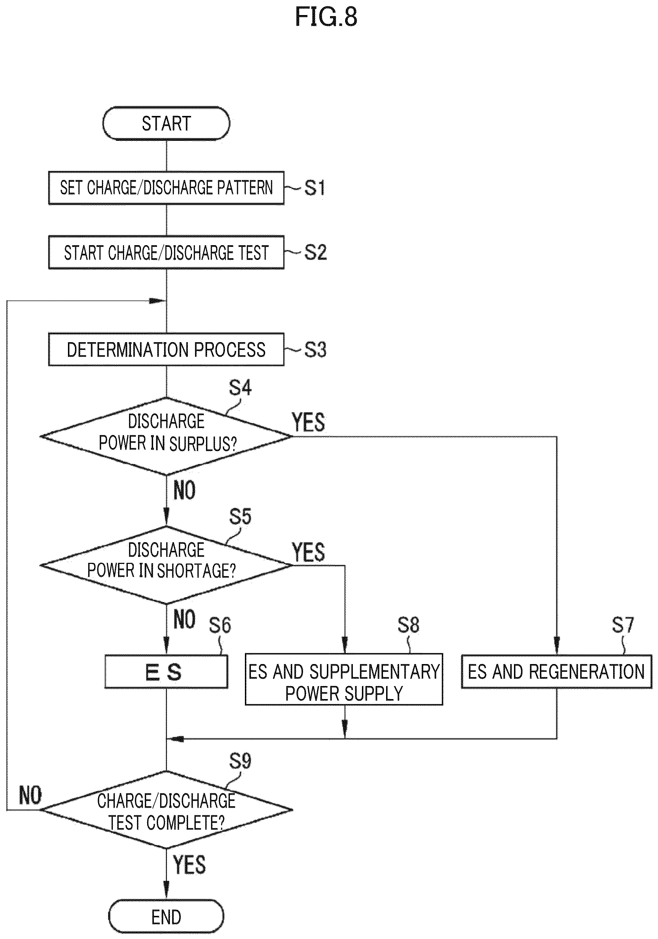

Figure 8 is a flowchart showing a control method for the charge/discharge test system 10 according to the first embodiment, especially a flow of a charge/discharge test on the two batteries 6 by the charge/discharge test system 10.

As shown in Figure 8, the operator first sets charge/discharge patterns (the charge patterns P1 and the discharge patterns P2) corresponding to the types and test purposes of the batteries 6 on the production line 7 in the main control device 18 (step S1). The main control device 18 outputs information on the input charge/discharge patterns to the ET control unit 28.

When the two batteries 6 on the production line 7 are conveyed to predetermined test positions, the two batteries 6 are separately and electrically connected to the two non-isolated bidirectional DC/DC converters 26 via the jointing part 19 and the like. The main control device 18 and the ET control unit 28 start a charge/discharge test on the two batteries 6 (step S2). Note that, for brevity of explanation, the two batteries 6 are assumed to be chargeable and dischargeable, i.e., be neither uncharged nor fully-charged.

The ET control unit 28 synchronizes charging of the battery 6-1 with discharging of the battery 6-2 as shown in Figure 3, and then makes a start to preferentially execute ES. In this case, the ET control unit 28 calculates the differential pattern P3 on the basis of the charge pattern P1 and the discharge pattern P2 as shown in Figure 4, and performs the determination process of determining whether there is a surplus or a shortage of current discharge power with respect to the current necessary charge power on the basis of the differential pattern P3 (step S3).

In the ideal state described earlier where there is no shortage and no surplus of the discharge power with respect to the necessary charge power, the ET control unit 28 controls the non-isolated bidirectional DC/DC converters 26 to execute only ES as shown in Figure 5 (NO in steps S4 and S5, and step S6). The use of power discharged from the battery 6-2 to charge the battery 6-1 via the non-isolated bidirectional DC/DC converter 26-2, the second DC bus 24, and the non-isolated bidirectional DC/DC converter 26-1 allows enhancement of power utilization efficiency of the charge/discharge test system 10.

When there is a surplus of the discharge power over the necessary charge power (YES in step S4), the ET control unit 28 executes ES, and executes regenerative return of surplus power together with the main control device 18 (step S7), as shown in Figure 6. With this operation, ES is preferentially executed, and only the surplus power is input from the battery 6-2 to the bidirectional AC/DC converter 12 via the non-isolated bidirectional DC/DC converter 26-2, the second DC bus 24, the isolated bidirectional DC/DC converter 22 and the first DC bus 14. The surplus power (DC power) is converted into AC power by the bidirectional AC/DC converter 12, and then the AC power is regeneratively returned to the AC power supply 9 via the AC bus 8. Even when there is surplus power, because the surplus power is preferentially used for execution of ES, it is possible to minimize surplus power to be regeneratively returned to the AC power supply 9. This results in enhancement of the power utilization efficiency of the charge/discharge test system 10.

When there is a shortage of the discharge power below the necessary charge power (NO in step S4 and YES in step S5), the ET control unit 28 executes ES, and executes supplementary power supply together with the main control device 18 (step S8), as shown in Figure 7. With this operation, ES is preferentially executed, and supplementary power (AC power) for supplementing power shortage in the ES is input from the AC power supply 9 to the bidirectional AC/DC converter 12 via the AC bus 8. The supplementary power is converted into DC power by the bidirectional AC/DC converter 12, and then the DC power is charged into the battery 6-1 via the first DC bus 14, the isolated bidirectional DC/DC converter 22, the second DC bus 24 and the non-isolated bidirectional DC/DC converter 26-1. Even when there is a shortage of discharge power below the necessary charge power, because ES is preferentially executed, it is possible to minimize supplementary power to be fed from the AC power supply 9. This results in enhancement of the power utilization efficiency of the charge/discharge test system 10.

The processes in step S3 and the subsequent steps are repeatedly executed until the charge/discharge test on the two batteries 6 is completed (NO in step S9). When the charge/discharge test on the two batteries 6 is completed (YES in step S9), two new batteries 6 on the production line 7 are conveyed to the test positions, and the processes in step S2 and the subsequent steps are repeatedly executed.

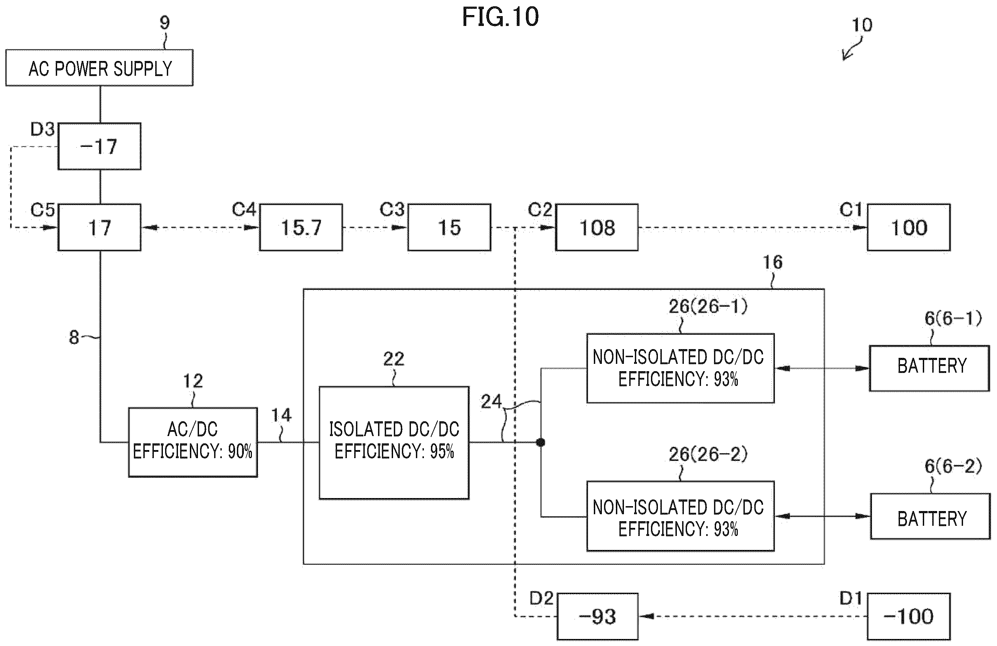

Figure 9 is an explanatory diagram for explaining power utilization efficiency of a charge/discharge test system 100 according to a comparative example. Figure 10 is an explanatory diagram for explaining the power utilization efficiency of the charge/discharge test system 10 according to the first embodiment.

Note that, in Figures 9 and 10, the bidirectional AC/DC converter 12 is referred to as "AC/DC," the isolated bidirectional DC/DC converter 22 and an isolated bidirectional DC/DC converter 104 are each referred to as "isolated DC/DC," and the non-isolated bidirectional DC/DC converter 26 is referred to as "non-isolated DC/DC." In a lower part of each converter in Figures 9 and 10, "efficiency of X%" (X here is an arbitrary integer) indicates conversion efficiency of each converter.

As shown in Figure 9, the charge/discharge test system 100 according to the comparative example includes two power supply devices 102 that are separately provided for two batteries 6. An AC bus 8 of the charge/discharge test system 100 includes two AC buses 8a and 8b for electrically connecting the two respective power supply devices 102 to an AC power supply 9. Note that, for brevity of explanation, the AC bus 8 and the AC buses 8a and 8b will be collectively referred to as the "AC buses 8" in the following description.

The two power supply devices 102 each include a bidirectional AC/DC converter 12, a first DC bus 14, and the isolated bidirectional DC/DC converter 104.

One end of each bidirectional AC/DC converter 12 is connected to the AC bus 8 and is further connected to the AC power supply 9 via the AC bus 8. The other end of each bidirectional AC/DC converter 12 is connected to the isolated bidirectional DC/DC converter 104 via each first DC bus 14. Each bidirectional AC/DC converter 12 converts AC power input from the AC power supply 9 via the AC bus 8 into DC power and outputs the DC power to the isolated bidirectional DC/DC converter 104 via the first DC bus 14. Each bidirectional AC/DC converter 12 also converts surplus power (DC power) input from the isolated bidirectional DC/DC converter 104 via the first DC bus 14 into AC power and then outputs the AC power to the AC power supply 9 via the AC bus 8.

Each isolated bidirectional DC/DC converter 104 is connected to one end of the isolated bidirectional DC/DC converter 104 via the first DC bus 14. A battery 6 is connected to the other end, which is on the opposite side from the one end, of the isolated bidirectional DC/DC converter 104 via a cable and a jointing part 19 (see Figure 1). The isolated bidirectional DC/DC converter 104 is basically the same as the isolated bidirectional DC/DC converter 22 except that conversion efficiency is different. The isolated bidirectional DC/DC converter 104 decreases a DC voltage input via the first DC bus 14 and then outputs the DC voltage to the battery 6 via the cable and the like, and increases a DC voltage input from the battery 6 via the cable and the like and then outputs the DC voltage to the bidirectional AC/DC converter 12 via the first DC bus 14.

Note that the isolated bidirectional DC/DC converter 104 connected to a battery 6-1 will be referred to as an "isolated bidirectional DC/DC converter 104-1" and the isolated bidirectional DC/DC converter 104 connected to a battery 6-2 will be referred to as an "isolated bidirectional DC/DC converter 104-2" as appropriate. The bidirectional AC/DC converter 12 connected to the isolated bidirectional DC/DC converter 104-1 via the first DC bus 14 will be referred to as a "bidirectional AC/DC converter 12-1," and the bidirectional AC/DC converter 12 connected to the isolated bidirectional DC/DC converter 104-2 via the first DC bus 14 will be referred to as a "bidirectional AC/DC converter 12-2."

In performing ES in the charge/discharge test system 100 according to the comparative example, power discharged from the battery 6-2 is charged into the battery 6-1 via the isolated bidirectional DC/DC converter 104-2, the first DC bus 14, the bidirectional AC/DC converter 12-2, the AC bus 8, the bidirectional AC/DC converter 12-1, the first DC bus 14 and the isolated bidirectional DC/DC converter 104-1.

Assume a case where a magnitude of power (electric current) discharged from the battery 6-2 is represented by a numerical value of "-100" and a magnitude of power (electric current) necessary to charge the battery 6-1 is represented by a numerical value of "100" in performing the above-described ES. Complementary power that needs to be fed from the AC power supply 9 in this case will be described. Note that although "kW" is used as a unit for numerical values, the unit may be, for example, "kA."

Power of "-100 kW" (see reference character D1) discharged from the battery 6-2 is reduced to power of "-80 kW" (= -100 kW × 0.8) denoted by reference character D2 through DC/DC conversion in the isolated bidirectional DC/DC converter 104-2 (efficiency of 80%). The power of "-80 kW" is reduced to power of "-72 kW" (= -80 kW × 0.9) denoted by reference character D3 through DC/AC conversion in the isolated bidirectional DC/DC converter 104-2 (efficiency of 90%).

To charge power of "100 kW" (see reference character C1) into the battery 6-1, power of "125 kW" (= 100 kW/0.8) denoted by reference character C2 needs to be input to the isolated bidirectional DC/DC converter 104-1 (efficiency of 80%). To input power of "125 kW" from the bidirectional AC/DC converter 12-1 to the isolated bidirectional DC/DC converter 104-1 via the first DC bus 14, power of "139 kW" (= 125 kW/0.9) denoted by reference character C3 needs to be input to the bidirectional AC/DC converter 12-1 (efficiency of 90%). For this reason, to charge power of "100 kW" into the battery 6-1, power of "-139 kW" needs to be secured.

Since power that can be covered by ES is -72 kW in the charge/discharge test system 100 according to the comparative example, power of "-67 kW" [= -139 kW - (-72 kW)] denoted by reference character D4 needs to be fed from the AC power supply 9 in order to secure power of "-139 kW" necessary to charge the battery 6-1.

In contrast, in ES to be executed by the charge/discharge test system 10 according to the first embodiment shown in Figure 10, power discharged from the battery 6-2 is charged into the battery 6-1 via the non-isolated bidirectional DC/DC converter 26-2, the second DC bus 24 and the isolated bidirectional DC/DC converter 104-1. For this reason, power of "-93 kW" (= -100 kW × 0.93) denoted by reference character D2 that is obtained by subtracting power consumed by the non-isolated bidirectional DC/DC converter 26-2 (efficiency of 93%) from power of "-100 kW" (see reference character D1) discharged from the battery 6-2, may be cover by ES.

To charge power of "100 kW" (see reference character C1) into the battery 6-1, power of "108 kW" (≈ 100 kW/0.93) denoted by reference character C2 needs to be input to the non-isolated bidirectional DC/DC converter 26-1 (efficiency of 93%). Power of "-93 kW" may be covered by ES in the first embodiment. For this reason, to charge power of "100 kW" into the battery 6-1, power of "15 kW" (= 108 kW - 93 kW) denoted by reference character C3 only needs to be fed from the isolated bidirectional DC/DC converter 22 to the non-isolated bidirectional DC/DC converter 26-2 via the second DC bus 24.

To feed power of "15 kW" to the non-isolated bidirectional DC/DC converter 26-1, power of "15.7 kW" (≈ 15 kW/0.95) denoted by reference character C4 needs to be input from the bidirectional AC/DC converter 12 to the isolated bidirectional DC/DC converter 22 (efficiency of 95%) via the first DC bus 14. To input power of "15.7 kW" to the isolated bidirectional DC/DC converter 22, power of "17 kW" (≈ 15.7 kW/0.9) denoted by reference character C5 needs to be input from the AC power supply 9 to the bidirectional AC/DC converter 12 (efficiency of 90%) via the AC bus 8.

Thus, in the charge/discharge test system 10 according to the first embodiment, to charge power of "100 kW" into the battery 6-1, power of "-17 kW" denoted by reference character D3 needs to be fed from the AC power supply 9. As described above, in the first embodiment, power to be fed from the AC power supply 9 may be largely reduced as compared to the comparative example. This causes a large enhancement in power utilization efficiency.

In the charge/discharge test system 100 according to the comparative example shown in Figure 9, the bidirectional AC/DC converter 12-1 needs to handle AC/DC conversion of power of "139 kW" (see reference character C3), and the bidirectional AC/DC converter 12 including a transformer of the 140-kW class needs to be used for each power supply device 102. Also, in the charge/discharge test system 100 according to the comparative example, the isolated bidirectional DC/DC converter 104-1 needs to handle DC/DC conversion of power of "125 kW" (see reference character C2), and the isolated bidirectional DC/DC converter 104 including a transformer of the 130-kW class needs to be used for each power supply device 102.

In contrast, in the charge/discharge test system 10 according to the first embodiment shown in Figure 10, because the bidirectional AC/DC converter 12 only needs to handle AC/DC conversion of power of "17 kW" (see reference character C5), the bidirectional AC/DC converter 12 including a transformer of the 20-kW class may be used. Also, in the charge/discharge test system 10 according to the first embodiment, because the isolated bidirectional DC/DC converter 22 only needs to handle DC/DC conversion of power of "15.7 kW" (see reference character C4), the isolated bidirectional DC/DC converter 22 including a transformer of the 20-kW class may be used. Additionally, since the non-isolated bidirectional DC/DC converter 26-1 needs to handle DC/DC conversion of power of "108 kW" (see reference character C2) in the charge/discharge test system 10 according to the first embodiment, two non-isolated bidirectional DC/DC converters 26 capable of handling processing of the 110-kW class need to be used. However, since the non-isolated bidirectional DC/DC converter 26 does not include a transformer, a size reduction and a cost reduction may be achieved.

As described above, the charge/discharge test system 10 according to the first embodiment may use the bidirectional AC/DC converter 12 of the 20-kW class and the non-isolated bidirectional DC/DC converter 26, and uses two non-isolated bidirectional DC/DC converters 26 without transformers, unlike the comparative example. This allows a size reduction and a cost reduction as compared with the comparative example.

As has been described above, in the charge/discharge test system 10 according to the first embodiment, the non-isolated bidirectional DC/DC converters 26 are electrically connected via the second DC bus 24 to enable ES between the respective batteries 6 electrically connected to the non-isolated bidirectional DC/DC converters 26. This implements enhancement of power utilization efficiency, a size reduction, and a cost reduction.

### [Second Embodiment]

A charge/discharge test system 10 according to a second embodiment will be described. The ET control unit 28 of the charge/discharge test system 10 according to the first embodiment calculates the differential pattern P3 as shown in Figure 4 and executes the determination process on the basis of the differential pattern P3, thereby controlling charging and discharging of two batteries 6. At this time, power is consumed by DC/DC conversion in each non-isolated bidirectional DC/DC converter 26, as shown in Figure 10 and the like. For this reason, power discharged from the battery 6-2 is reduced by an amount corresponding to power consumed by the non-isolated bidirectional DC/DC converter 26-2, and power charged into the battery 6-1 is also reduced by an amount corresponding to power consumed by the non-isolated bidirectional DC/DC converter 26-1.

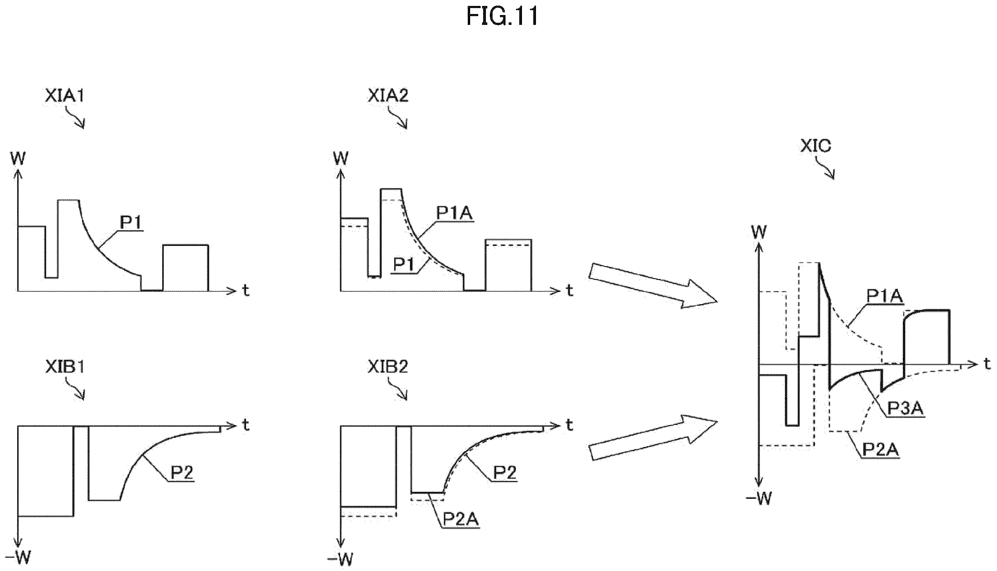

Under the circumstances, an ET control unit 28 of the charge/discharge test system 10 according to the second embodiment calculates a differential pattern P3A based on consideration of power consumed by non-isolated bidirectional DC/DC converters 26, as shown in Figure 11. Figure 11 is an explanatory chart for explaining calculation of the differential pattern P3A by the ET control unit 28 according to the second embodiment. Note that the charge/discharge test system 10 according to the second embodiment is basically the same in configuration as the charge/discharge test system 10 according to the first embodiment except that a calculation method for the differential pattern P3A by the ET control unit 28 is different. For this reason, components identical in function or configuration to those in the first embodiment are denoted by identical reference numerals, and a description thereof will be omitted.

The ET control unit 28 according to the second embodiment corrects the charge pattern P1 so as to increase power by an amount corresponding to power consumed by the non-isolated bidirectional DC/DC converter 26 (26-1), to generate a charge pattern P1A, as indicated by reference characters XIA1 and XIA2. The ET control unit 28 also corrects the discharge pattern P2 so as to reduce power by an amount corresponding to power consumed by the non-isolated bidirectional DC/DC converter 26 (26-2), to generate a discharge pattern P2A, as indicated by reference characters XIB1 and XIB2.

The ET control unit 28 calculates the differential pattern P3A corresponding to a difference between the charge pattern P1A and the discharge pattern P2A, as indicated by reference character XIC, to perform the determination process based on the differential pattern P3A. This makes it possible to determine whether there is a shortage or a surplus of discharge power with respect to the necessary charge power in consideration of power consumed by the non-isolated bidirectional DC/DC converters 26. Processes subsequent to the determination process are the same as in the first embodiment, and a specific description thereof will be omitted.

As has been described above, since correction corresponding to power consumed by the non-isolated bidirectional DC/DC converters 26 is performed on the charge pattern P1 and the discharge pattern P2 in the second embodiment, ES reflecting the consumed power may be executed.

### [Third Embodiment]

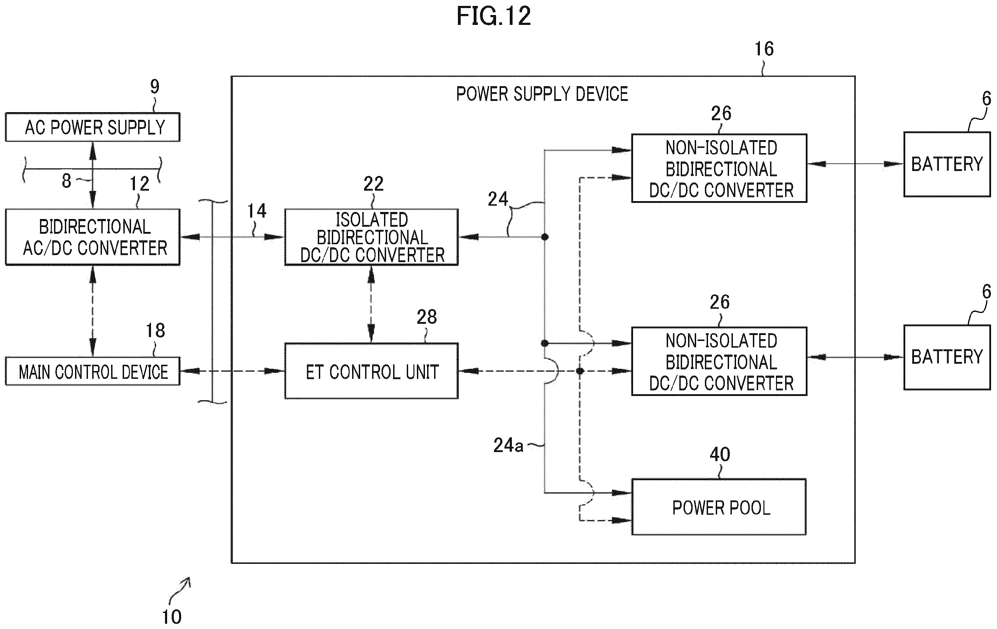

Figure 12 is a block diagram of a charge/discharge test system 10 according to a third embodiment. In the charge/discharge test systems 10 of the above-described embodiments, regenerative return of surplus power to the AC power supply 9 is executed when there is a surplus of discharge power over the necessary charge power, and supplementary power supply from the AC power supply 9 is executed when there is a shortage of discharge power below the necessary charge power. In contrast, in the charge/discharge test system 10 according to the third embodiment, a power pool 40 is used to enable execution of charging of surplus power and discharging of supplementary power.

As shown in Figure 12, the charge/discharge test system 10 according to the third embodiment is basically the same in configuration as the charge/discharge test systems 10 of the above-described embodiments except that the power supply device 16 includes the power pool 40 (also called an energy pool) and that the second DC bus 24 includes a second DC bus 24a. For this reason, components identical in function or configuration to those in the embodiments are denoted by identical reference numerals, and a description thereof will be omitted.

The power pool 40 is electrically connected to the non-isolated bidirectional DC/DC converters 26 and the isolated bidirectional DC/DC converter 22 via the second DC bus 24a and the second DC bus 24. Note that, for brevity of explanation, the second DC bus 24 and the second DC bus 24a will be collectively referred to as the "second DC buses 24" in the following description.

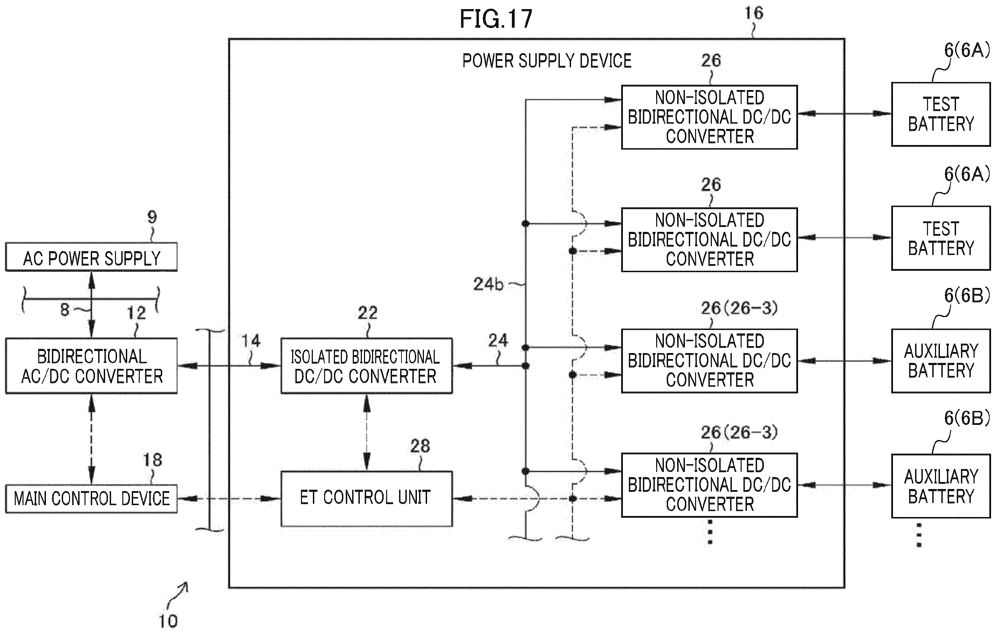

The power pool 40 is not particularly limited as long as a device such as a lithium ion capacitor and various types of batteries, that may be subjected to charge/discharge control by an ET control unit 28 is used. Note that a surplus converter 26-3, an auxiliary battery 6B, and the like shown in Figure 17 (to be described later) may be included in the power pool 40. Although the power pool 40 is provided inside the power supply device 16 in Figure 12, the power pool 40 may be provided outside the power supply device 16.

The ET control unit 28 according to the third embodiment has a function of continuously detecting a current charge amount (dischargeable capacity) and a chargeable capacity of the power pool 40, current power consumption used to charge the power pool 40, and current discharge power discharged from the power pool 40, in addition to a function of performing charge/discharge control on the power pool 40. The ET control unit 28 controls charging and discharging of two batteries 6 and the power pool 40 to execute the ES described above or execute power pool-based ES on the basis of a result of a determination process executed in the same manner as in the embodiments. The power pool-based ES here refers to executing charging of surplus power into the power pool 40 or discharging of supplementary power from the power pool 40, together with ES.

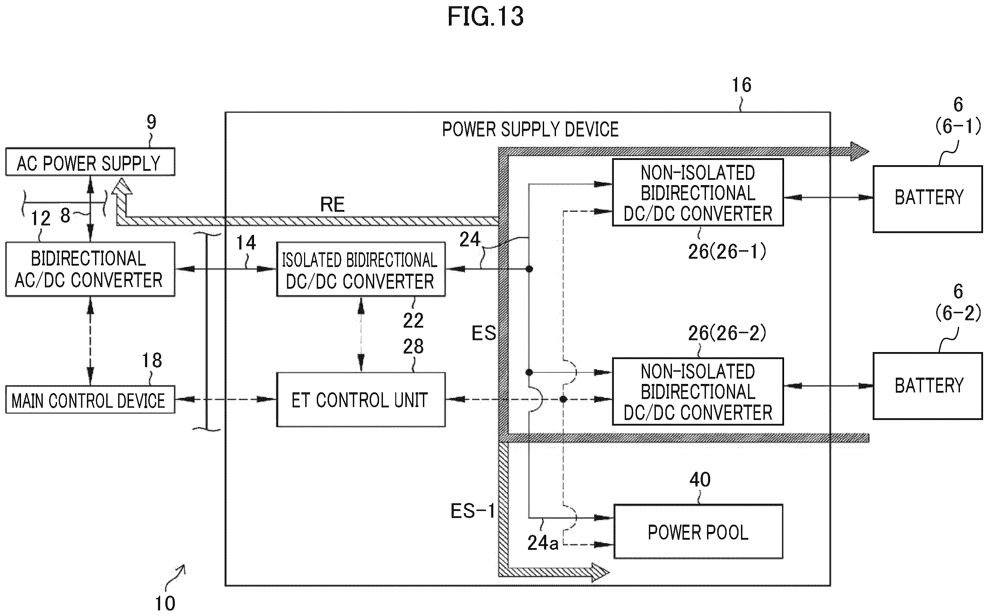

Figure 13 is an explanatory diagram for explaining power pool-based ES and regenerative return of surplus power to an AC power supply 9 when there is a surplus of discharge power over the necessary charge power. As shown in Figure 13, the ET control unit 28 executes, as power pool-based ES, the ES described earlier and charging of surplus power into the power pool 40 in a case where a result of the determination process indicates that there is a surplus of discharge power over the necessary charge power.

Specifically, the ET control unit 28 controls the two non-isolated bidirectional DC/DC converters 26 to execute ES such that a part of the discharge power is used to charge the battery 6-1 by an amount corresponding to the necessary charge power, as in the embodiments.

The ET control unit 28 controls the non-isolated bidirectional DC/DC converter 26-2 and the power pool 40, to output the surplus power to the power pool 40 and charge the power pool 40. With this operation, the surplus power is input from a battery 6-2 to the power pool 40 via the non-isolated bidirectional DC/DC converter 26-2 and the second DC bus 24, and the power pool 40 is charged with the surplus power (see reference character ES-1).

When the surplus power is equal to or less than the chargeable capacity of the power pool 40, the whole of the surplus power is charged into the power pool 40. On the other hand, when the surplus power exceeds the chargeable capacity of the power pool 40, the ET control unit 28 controls the non-isolated bidirectional DC/DC converter 26-2 and the isolated bidirectional DC/DC converter 22, to output a part of the surplus power by an amount corresponding to an excess (hereinafter referred to as excess power) over the chargeable capacity to a bidirectional AC/DC converter 12. With this operation, the excess power is input from the battery 6-2 to the bidirectional AC/DC converter 12 via the non-isolated bidirectional DC/DC converter 26-2, the second DC bus 24, the isolated bidirectional DC/DC converter 22 and a first DC bus 14.

When there is the excess power, a main control device 18 according to the third embodiment actuates the bidirectional AC/DC converter 12. The bidirectional AC/DC converter 12 converts the excess power (DC power) input from the power supply device 16 via the first DC bus 14 into AC power and then regeneratively returns the AC power to the AC power supply 9 via the AC bus 8 (see reference character RE).

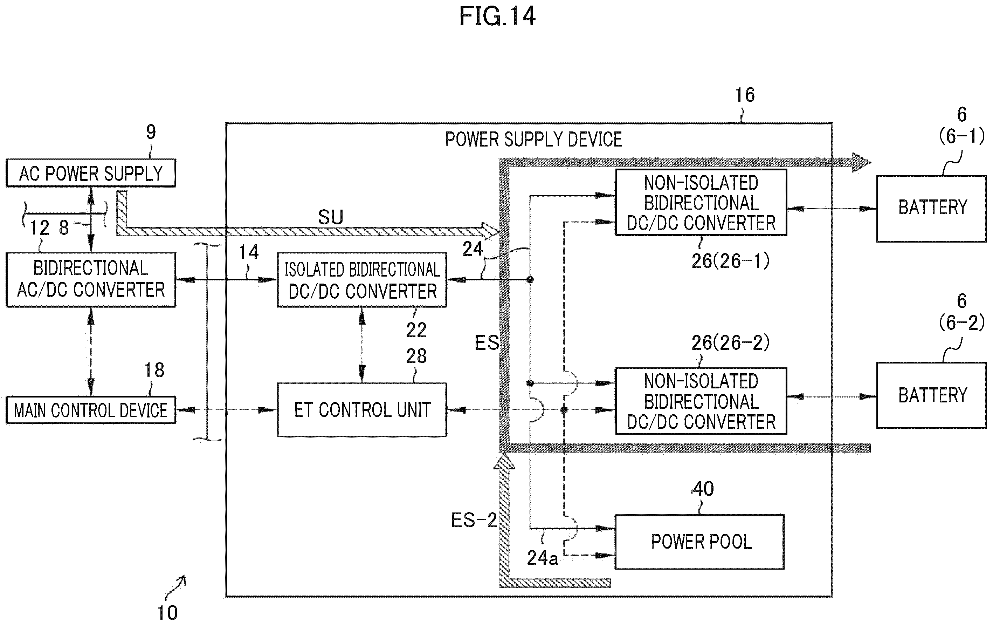

Figure 14 is an explanatory diagram for explaining power pool-based ES and supplementary power supply from the AC power supply 9 in a case where there is a shortage of the discharge power below the necessary charge power. As shown in Figure 14, in a case where a result of the determination process indicates that there is a shortage of the discharge power below the necessary charge power, the ET control unit 28 executes, as power pool-based ES, both the ES described earlier and discharging of supplementary power from the power pool 40.

Specifically, the ET control unit 28 controls the two non-isolated bidirectional DC/DC converters 26 to execute ES. With this operation, the whole (excluding power consumed by the non-isolated bidirectional DC/DC converters 26) of power discharged from the battery 6-2 is charged into the battery 6-1 via the non-isolated bidirectional DC/DC converter 26-2, the second DC bus 24, and a non-isolated bidirectional DC/DC converter 26-1.

The ET control unit 28 also controls the non-isolated bidirectional DC/DC converter 26-1 and the power pool 40 to execute discharging of supplementary power from the power pool 40. With this operation, the supplementary power is input from the power pool 40 to the battery 6-1 via the second DC bus 24 and the non-isolated bidirectional DC/DC converter 26-1, such that the battery 6-1 is charged with the supplementary power (see reference character ES-2).

In a case where a shortage amount of discharge power with respect to the necessary charge power is less than the dischargeable capacity of the power pool 40, the shortage amount of the discharge power with respect to the necessary charge power may be covered only by supplementary power discharged from the power pool 40. On the other hand, in a case where the shortage amount of the discharge power exceeds the dischargeable capacity of the power pool 40, the main control device 18 and the ET control unit 28 execute additional supplementary power supply in order to cover a shortage amount of the dischargeable capacity of the power pool 40 with additional supplementary power from the AC power supply 9.

Specifically, the main control device 18 actuates the bidirectional AC/DC converter 12. The bidirectional AC/DC converter 12 receives supply of the additional supplementary power (AC power) that covers the shortage amount of the dischargeable capacity of the power pool 40 from the AC power supply 9 via the AC bus 8, converts the additional supplementary power into DC power, and then outputs the DC power to the isolated bidirectional DC/DC converter 22 via the first DC bus 14 (see reference character SU).

The ET control unit 28 controls the isolated bidirectional DC/DC converter 22 and the non-isolated bidirectional DC/DC converter 26-1 to input the additional supplementary power from the isolated bidirectional DC/DC converter 22 to the battery 6-1 via the second DC bus 24 and the non-isolated bidirectional DC/DC converter 26-1 and charge the battery 6-1 with the additional supplementary power.

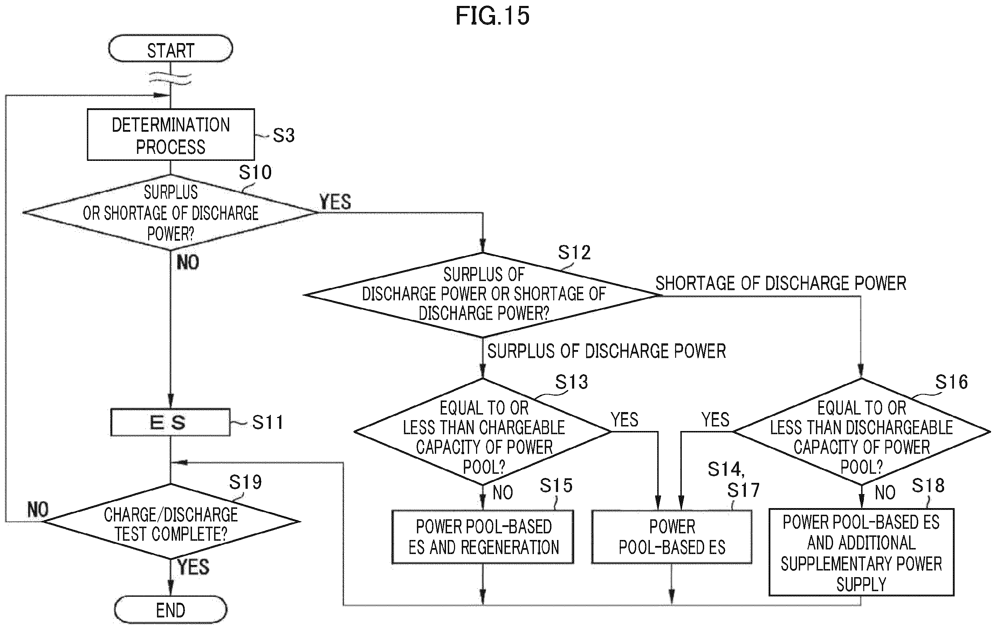

Figure 15 is a flowchart showing a flow of a charge/discharge test on the two batteries 6 by the charge/discharge test system 10 according to the third embodiment. Note that a flow of processes up to step S3 is the same as in the first embodiment described with reference to Figure 8, and a description thereof will be omitted.

In a case where there is no shortage nor surplus of the discharge power with respect to the necessary charge power, the ET control unit 28 controls the non-isolated bidirectional DC/DC converters 26 to execute only ES (NO in step S10, and step S11), as in the first embodiment.

In a case where there is a surplus of the discharge power over the necessary charge power, the ET control unit 28 determines whether an amount of the surplus power is equal to or less than the chargeable capacity of the power pool 40 (YES in step S10, step S12, and step S13).

In a case where the ET control unit 28 determines that the amount of the surplus power is equal to or less than the chargeable capacity of the power pool 40, the ET control unit 28 controls the non-isolated bidirectional DC/DC converters 26 and the power pool 40 to execute power pool-based ES (YES in step S13, and step S14), as shown in Figure 13. With this operation, ES is preferentially executed, and only a rest of the surplus power left after the ES is charged from the battery 6-2 into the power pool 40 via the non-isolated bidirectional DC/DC converter 26-2 and the second DC bus 24. In this case, regenerative return of the surplus power to the AC power supply 9 need not be performed, unlike in the above-described embodiments. Additionally, since the surplus power is temporarily charged into the power pool 40 connected to the second DC bus 24, power utilization efficiency of the charge/discharge test system 10 may be further enhanced.

On the other hand, in a case where the ET control unit 28 determines that the amount of the surplus power exceeds the chargeable capacity of the power pool 40, the ET control unit 28 controls the non-isolated bidirectional DC/DC converters 26 and the power pool 40 to execute power pool-based ES, and executes regenerative return of excess power together with the main control device 18 (NO in step S13, and step S15), as shown in Figure 13. With this operation, the power pool-based ES as in step S14 is executed, and only the excess power that cannot be charged into the power pool 40 is input to the bidirectional AC/DC converter 12 via the second DC bus 24, the isolated bidirectional DC/DC converter 22, and the first DC bus 14. The excess power (DC power) is converted into AC power by the bidirectional AC/DC converter 12 and is then regeneratively returned to the AC power supply 9 via the AC bus 8. Since the power pool-based ES minimizes the amount of the surplus power to be regeneratively returned to the AC power supply 9, the power utilization efficiency of the charge/discharge test system 10 may be enhanced.

In a case where there is a shortage of the discharge power below the necessary charge power, the ET control unit 28 determines whether a shortage amount of the discharge power below the necessary charge power is equal to or less than the dischargeable capacity of the power pool 40 (YES in step S10, step S12, and step S16).

In a case where the ET control unit 28 determines that the shortage amount of the discharge power is equal to or less than the dischargeable capacity of the power pool 40, the ET control unit 28 controls the non-isolated bidirectional DC/DC converters 26 and the power pool 40 to execute power pool-based ES (YES in step S16, and step S17), as shown in Figure 13. With this operation, ES is preferentially executed, and supplementary power that covers a shortage amount in the execution of the ES is discharged from the power pool 40. The supplementary power is charged into the battery 6-1 via the second DC bus 24 and the non-isolated bidirectional DC/DC converter 26-1. In this case, since the whole of the supplementary power may be supplemented from the power pool 40, supplementary power supply from the AC power supply 9 need not be performed, unlike in the embodiments. This allows further enhancement of the power utilization efficiency of the charge/discharge test system 10.

On the other hand, in a case where the ET control unit 28 determines that the shortage amount of the discharge power exceeds the dischargeable capacity of the power pool 40, the ET control unit 28 controls the non-isolated bidirectional DC/DC converters 26 and the power pool 40 to execute power pool-based ES, and further executes additional supplementary power supply, together with the main control device 18 (NO in step S16, and step S18), as shown in Figure 14. With this operation, the power pool-based ES as in step S17 is executed, and additional supplementary power is charged from the AC power supply 9 into the battery 6-1 via the AC bus 8, the bidirectional AC/DC converter 12, the first DC bus 14, the isolated bidirectional DC/DC converter 22, the second DC bus 24, and the non-isolated bidirectional DC/DC converter 26-1. Since the power pool-based ES minimizes amount of additional supplementary power to be fed from the AC power supply 9, the power utilization efficiency of the charge/discharge test system 10 may be enhanced.

Until the charge/discharge test on the two batteries 6 is completed, the above-described processes in step S3 and the subsequent steps are repeatedly executed (NO in step S19). When the charge/discharge test on the two batteries 6 is completed (YES in step S19), two new batteries 6 on a production line 7 are conveyed to test positions, and the above-described processes are repeatedly executed.

As has been described above, in the charge/discharge test system 10 according to the third embodiment, the power pool 40 is connected to the second DC bus 24, and the power pool-based ES using the power pool 40 is executed. This allows further enhancement of the power utilization efficiency of the charge/discharge test system 10.

### [Fourth Embodiment]

Figure 16 is a block diagram of a charge/discharge test system 10 according to a fourth embodiment. Two batteries 6 are electrically connected to the power supply device 16 in the charge/discharge test systems 10 of the above-described embodiments. On the other hand, three or more batteries 6 are electrically connected to the power supply device 16 in the charge/discharge test system 10 according to the fourth embodiment, as shown in Figure 16. Note that the charge/discharge test system 10 according to the fourth embodiment is basically the same in configuration as the charge/discharge test systems 10 according to the above-described embodiments except that the power supply device 16 has a different configuration. For this reason, components identical in function or configuration to those in the embodiments are denoted by identical reference numerals, and a description thereof will be omitted.

The power supply device 16 according to the fourth embodiment is basically the same in configuration as the power supply devices 16 of the embodiments, except that the power supply device 16 includes three or more non-isolated bidirectional DC/DC converters 26 and that the second DC bus 24 includes a second DC bus 24b that electrically connects the three or more non-isolated bidirectional DC/DC converters 26 in parallel to an isolated bidirectional DC/DC converter 22. Note that, for brevity of explanation, the second DC bus 24 and the second DC bus 24b will be collectively referred to as the "second DC buses 24" in the following description.

The respective batteries 6 are connected to the non-isolated bidirectional DC/DC converters 26 via a jointing part 19 (see Figure 1) and the like in the same manner as in the embodiments. Thus, the power supply device 16 according to the fourth embodiment may execute a charge/discharge test on the three or more batteries 6.

When three or more batteries 6 are electrically connected to the power supply device 16, the ET control unit 28 according to the fourth embodiment synchronizes a charge timing for charging at least one battery 6 based on a charge pattern P1 with a discharge timing for discharging at least one battery 6 based on a discharge pattern P2, in order to execute ES.

The ET control unit 28 according to the fourth embodiment calculates a combined charge pattern obtained by combining charge patterns P1 for all batteries 6-1 to be charged and a combined discharge pattern obtained by combining discharge patterns P2 for all batteries 6-2 to be discharged (both not shown), on the basis of charge/discharge patterns (the charge patterns P1 and the discharge patterns P2) set for the respective batteries 6. In this case, the combined charge pattern indicates a temporal change in necessary charge power necessary to charge all the batteries 6 to be charged, and the combined discharge pattern indicates a temporal change in discharge power discharged from all the batteries 6 to be discharged.

Here, in a case where correction is performed corresponding to an amount of power consumed by the non-isolated bidirectional DC/DC converters 26 as described in the second embodiment, the combined charge pattern is corrected so as to increase power by an amount corresponding to power consumed by the non-isolated bidirectional DC/DC converters 26-1. In addition, the combined discharge pattern is corrected so as to reduce power by an amount corresponding to power consumed by the non-isolated bidirectional DC/DC converters 26.

The ET control unit 28 according to the fourth embodiment performs the determination process described earlier on the basis of a differential pattern (not shown) between the combined charge pattern and the combined discharge pattern, and controls charging and discharging of the batteries 6 on the basis of a result of the determination process such that ES is preferentially executed. With this operation, power output from at least one battery 6-2 via the non-isolated bidirectional DC/DC converter 26-2 is charged into at least one battery 6-1 via the second DC bus 24 and at least one non-isolated bidirectional DC/DC converter 26-1.

In a case where there is shortage or surplus of the discharge power with respect to the necessary charge power in the fourth embodiment, regenerative return to the AC power supply 9 or supplementary power supply described in the embodiments is executed. Further, power pool-based ES described in the third embodiment may be executed in the fourth embodiment.

As has been described above, the charge/discharge test system 10 according to the fourth embodiment increases the number of batteries 6 to be subjected to a charge/discharge test more than in the embodiments so as to further improve efficiency of the charge/discharge test than in the embodiments.

### [Fifth Embodiment]

Figure 17 is a block diagram of a charge/discharge test system 10 according to a fifth embodiment. In the charge/discharge test systems 10 according to the above-described embodiments, all batteries 6 electrically connected to the power supply device 16 are objects of a charge/discharge test. In contrast, in the charge/discharge test system 10 according to the fifth embodiment, batteries 6 that are objects of charge/discharge test and one or more batteries 6 that are not objects of charge/discharge test are electrically connected to a power supply device 16.

As shown in Figure 17, the charge/discharge test system 10 according to the fifth embodiment is basically the same in configuration as the charge/discharge test systems 10 according to the above-described embodiments except that the batteries 6 that are not objects of charge/discharge test are electrically connected to the power supply device 16. For this reason, components identical in function or configuration to those in the embodiments are denoted by identical reference numerals, and a description thereof will be omitted.

Batteries 6 electrically connected to non-isolated bidirectional DC/DC converters 26 according to the fifth embodiment include: test batteries 6A (corresponding to a test charge/discharge target of the present invention) as the batteries 6 that are objects of charge/discharge test; and one or more auxiliary batteries 6B (corresponding to an auxiliary charge/discharge target of the present invention) as the batteries 6 that are not objects of charge/discharge test. Note that the auxiliary batteries 6B are arranged at a place other than a production line 7. For example, the auxiliary batteries 6B are arranged in a thermostatic chamber (also referred to as a rack).

The test battery 6A and the auxiliary battery 6B are different from each other in that the test battery 6A is the battery 6 that is an object of charge/discharge test, while the auxiliary battery 6B is not an object of charge/discharge test. However, For example, the types of both batteries may be the same or not the same. Hereinafter, each non-isolated bidirectional DC/DC converter 26 that is electrically connected to each auxiliary battery 6B will be referred to as a "surplus converter 26-3" as appropriate. Note that each non-isolated bidirectional DC/DC converter 26 electrically connected to each test battery 6A corresponds to a converter under test of the present invention.

The auxiliary battery 6B and the surplus converter 26-3 fulfill the same role as that of the power pool 40 described in the third embodiment. The ET control unit 28 according to the fifth embodiment calculates a combined charge pattern obtained by combining charge patterns P1 for all test batteries 6A to be charged and a combined discharge pattern obtained by combining discharge patterns P2 for all test batteries 6A to be discharged. The ET control unit 28 performs the determination process described earlier on the basis of a differential pattern (not shown) between the combined charge pattern and the combined discharge pattern. In a case where a result of the determination process indicates that there is a surplus of discharge power over the necessary charge power, charging of surplus power into the auxiliary battery 6B is executed, in addition to execution of the ES described earlier.

Specifically, the ET control unit 28 controls at least one non-isolated bidirectional DC/DC converter 26-2 and at least one surplus converter 26-3, to charge at least one auxiliary battery 6B with the surplus power. With this operation, the surplus power output from at least one test battery 6A (battery 6-2) via the non-isolated bidirectional DC/DC converter 26-2 is charged into the at least one auxiliary battery 6B via the second DC bus 24 and the at least one surplus converter 26-3.

Note that, in a case where the surplus power exceeds a chargeable capacity of all auxiliary batteries 6B, excess power corresponding to an excess amount is regeneratively returned to an AC power supply 9 as in the third embodiment.

On the other hand, in a case where the result of the determination process indicates that there is a shortage of the discharge power below the necessary charge power, the ET control unit 28 executes discharging of supplementary power from the auxiliary batteries 6B, in addition to the execution of the ES described earlier. Specifically, the ET control unit 28 controls at least one surplus converter 26-3 and at least one non-isolated bidirectional DC/DC converter 26-1, to execute discharging of the supplementary power from at least one auxiliary battery 6B. With this operation, the supplementary power output from the at least one auxiliary battery 6B via the surplus converter 26-3 is charged into at least one test battery 6A (battery 6-1) via the second DC bus 24 and the at least one non-isolated bidirectional DC/DC converter 26-1.

Note that, in a case where a shortage amount of the discharge power below the necessary charge power cannot be covered (supplemented) only by the supplementary power discharged from all auxiliary batteries 6B, additional supplementary power supply is executed in order to cover a shortage amount of the supplementary power, with additional supplementary power from the AC power supply 9, as in the third embodiment.

As has been described above, the charge/discharge test system 10 according to the fifth embodiment charges the surplus power into the auxiliary battery 6B or supplies the supplementary power from the auxiliary battery 6B, thereby minimizing an amount of the surplus power to be regeneratively returned to the AC power supply 9, and an amount of the supplementary power to be supplied from the AC power supply 9. This results in enhancement of power utilization efficiency of the charge/discharge test system 10, as in the third embodiment. The use of the auxiliary battery 6B eliminates the need to provide the power pool 40, unlike in the third embodiment. This achieves a reduction in the cost of the charge/discharge test system 10.

### [Sixth Embodiment]

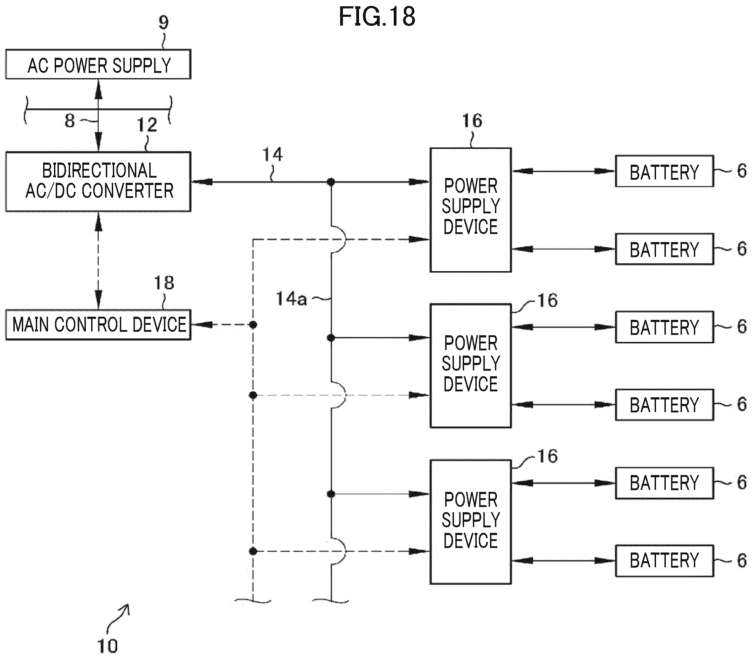

Figure 18 is a block diagram of a charge/discharge test system 10 according to a sixth embodiment. Although the charge/discharge test systems 10 according to the above-described embodiments include one power supply device 16, the charge/discharge test system 10 according to the sixth embodiment includes a plurality of power supply devices 16 and may execute inter-power supply device ES (to be described later) between the power supply devices 16 (one or more batteries 6 connected to each power supply device 16) that are different from each other. Note that the charge/discharge test system 10 according to the sixth embodiment is basically the same in configuration as the charge/discharge test systems 10 of the embodiments except that the charge/discharge test system 10 includes the plurality of power supply devices 16. For this reason, components identical in function or configuration to those in the embodiments are denoted by identical reference numerals, and a description thereof will be omitted.

The first DC bus 14 according to the sixth embodiment includes a first DC bus 14a that connects a bidirectional AC/DC converter 12 to at least one power supply device 16. Thus, the plurality of power supply devices 16 are electrically connected to the other end of the bidirectional AC/DC converter 12 via the first DC buses 14 and 14a. Note that, for brevity of explanation, the first DC bus 14 and the first DC bus 14a will be collectively referred to as the "first DC buses 14" in the following description.

The power supply devices 16 according to the sixth embodiment may be the power supply devices 16 according to any one of the embodiments, or may be any combination of the power supply devices 16 according to any of the embodiments. A description will be given below on the assumption that the plurality of power supply devices 16 are the power supply devices 16 according to the first embodiment or the second embodiment.

A main control device 18 according to the sixth embodiment sequentially acquires a result of the above-described determination process by an ET control unit 28 for each power supply device 16, to sequentially determine, for each power supply device 16, whether there is a surplus and a surplus of the discharge power with respect to the necessary charge power. In a case where, among the plurality of power supply devices 16, there is a shortage of the discharge power in at least one power supply device 16 and there is a surplus of discharge power in at least one power supply device 16, the main control device 18 preferentially executes inter-power supply device ES that is power supply from the latter to the former. That is, in a case where at least one power supply device 16 of the plurality of power supply devices 16 runs short of power necessary to charge the battery 6, and at least one power supply device 16 may output power (supply power) to the other power supply devices 16, inter-power supply device ES is preferentially executed.

To execute the inter-power supply device ES, the main control device 18 synchronizes timings for charge/discharge tests of the power supply devices 16 that are different from each other. In each power supply device 16, a charge timing for charging of one of two batteries 6 is synchronized with a discharge timing for discharging of the other of the two batteries 6, as described earlier.

In a case where there is a surplus of power or a shortage of power even after inter-power supply device ES is executed, the main control device 18 executes regenerative return to the AC power supply 9 or supply of supplementary power from the AC power supply 9.

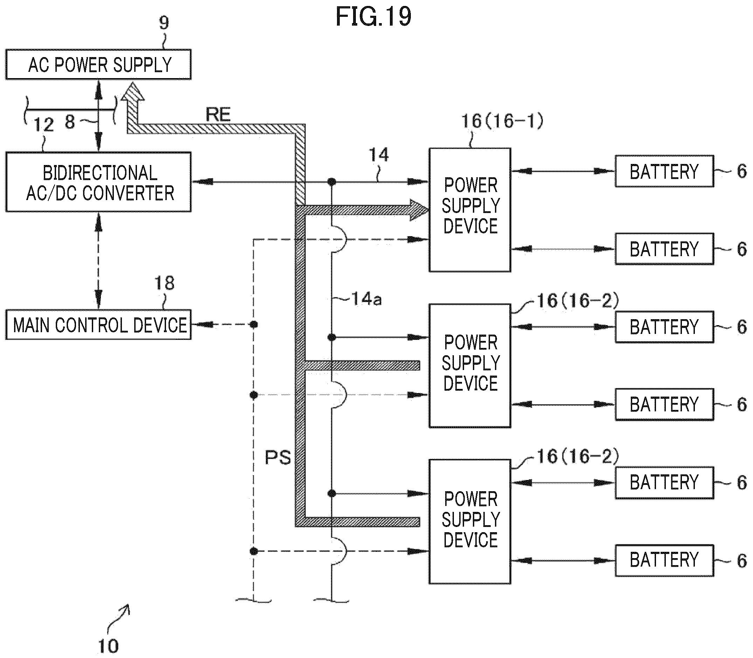

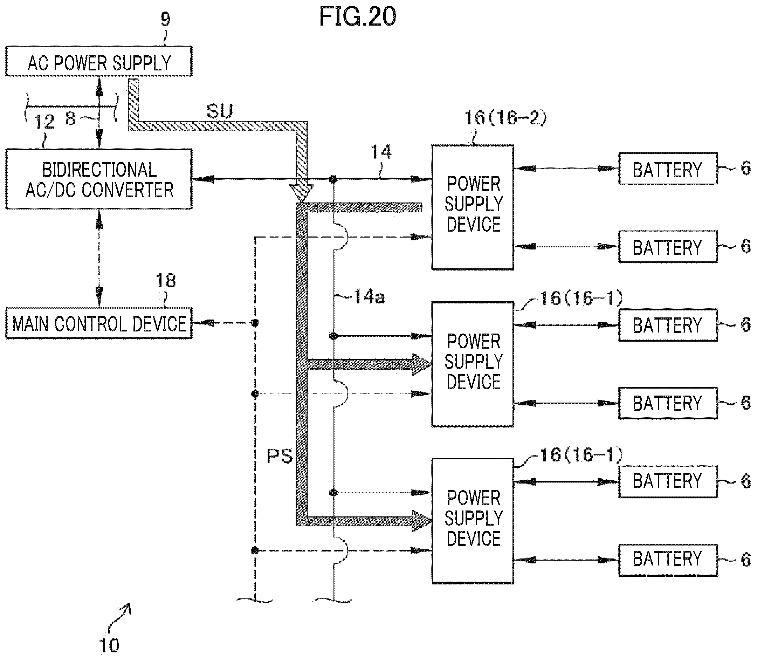

Figure 19 is an explanatory diagram for explaining inter-power supply device ES and regenerative return of surplus power to the AC power supply 9. Figure 20 is an explanatory diagram for explaining inter-power supply device ES and supplementary power supply from the AC power supply 9. Hereinafter, the power supply device 16 with a shortage of discharge power below the necessary charge power will be referred to as a "power supply device 16-1" as appropriate, and the power supply device 16 with a surplus of discharge power over the necessary charge power will be referred to as a "power supply device 16-2" as appropriate.

As shown in Figures 19 and 20, when the charge/discharge test system 10 includes both the power supply device(s) 16-1 and the power supply device(s) 16-2, the main control device 18 controls both of the power supply devices based on a results of the determination process for the respective power supply devices 16 by the ET control unit 28, to execute inter-power supply device ES. With this operation, surplus power is supplied from at least one power supply device 16-2 to at least one power supply device 16-1 via the first DC bus 14 (see reference character PS). As a result, the surplus power is used to charge the battery 6 in the at least one power supply device 16-1.

In a case where a sum of surplus amounts of discharge power in all power supply devices 16-2 is larger than a sum of shortage amounts of discharge power in all power supply devices 16-1, the main control device 18 controls the bidirectional AC/DC converter 12 and at least one power supply device 16-2 to regeneratively return surplus power that is left even after execution of inter-power supply device ES, as shown in Figure 19. With this operation, the surplus power is regeneratively returned to the AC power supply 9 via the first DC bus 14, the bidirectional AC/DC converter 12 and the AC bus 8 (see reference character RE).

On the other hand, in a case where the sum of the shortage amounts of discharge power in all the power supply devices 16-1 is larger than the sum of the surplus amounts of discharge power in all the power supply devices 16-2, the main control device 18 controls the bidirectional AC/DC converter 12 and at least one power supply device 16-1 to feed supplementary power that cannot be covered by inter-power supply device ES, from the AC power supply 9, as shown in Figure 20. Thus, the supplementary power is supplied to the at least one power supply device 16-1 via the AC bus 8, the bidirectional AC/DC converter 12 and the first DC bus 14, and is used in the power supply device 16-1 to charge the battery 6 (see reference character SU).

As has been described above, according to the sixth embodiment, when a plurality of power supply devices 16 are provided, inter-power supply device ES is executed so as to reduce surplus power to be regeneratively returned to the AC power supply 9 and supplementary power to be supplied from the AC power supply 9. This further enhances power utilization efficiency of the charge/discharge test system 10.

Here, the sixth embodiment explains, for an example, a case where power supply devices 16 according to the first embodiment or the second embodiment are used as the plurality of power supply devices 16. However, inter-power supply device ES may also be executed in a case where power supply devices 16 according to the fourth embodiment which control charging and discharging of three or more batteries 6 are used as the plurality of power supply devices 16, as in the sixth embodiment.

Further, inter-power supply device ES may also be executed in a case where power supply devices 16 according to the third embodiment which include the power pool 40 or power supply devices 16 according to the fifth embodiment which are electrically connected to the auxiliary batteries 6B, are used as the plurality of power supply devices 16, as in the sixth embodiment. In this case, among the plurality of power supply devices 16, when a shortage of discharge power below the necessary charge power exceeds a dischargeable capacity of the power pool 40 or the auxiliary battery 6B in at least one power supply device 16 and a surplus of discharge power over the necessary charge power exceeds a chargeable capacity of the power pool 40 or the auxiliary battery 6B in at least one power supply device 16, the main control device 18 executes inter-power supply device ES.

### [Others]

While a description has been given in each of the above-described embodiments, taking as an example a case where a charge/discharge test is performed on a plurality of batteries 6 on the production line 7, the present invention is applicable to a charge/discharge test on a plurality of batteries 6 arranged at an arbitrary place, such as in a thermostatic chamber.

Although the battery 6 has been described as an example of the charge/discharge target of the present invention in the embodiments, the charge/discharge target is not particularly limited as long as the charge/discharge target may be an object of charge/discharge test, such as a motor including a capacitor and a power converter.

### Reference Signs List

6 battery
6-1 battery
6-2 battery
6A test battery
6B auxiliary battery
7 production line
8 AC bus
8a AC bus
8b AC bus
9 AC power supply
10 charge/discharge test system
12 bidirectional AC/DC converter
12-1 bidirectional AC/DC converter
12-2 bidirectional AC/DC converter
14 first DC bus
14a first DC bus
16 power supply device
16-1 power supply device
16-2 power supply device
18 main control device
19 jointing part
22 isolated bidirectional DC/DC converter
24 second DC bus
24a second DC bus
24b second DC bus
26 non-isolated bidirectional DC/DC converter
26-1 non-isolated bidirectional DC/DC converter
26-2 non-isolated bidirectional DC/DC converter
26-3 surplus converter
28 ET control unit
40 power pool
100 charge/discharge test system
102 power supply device
104 isolated bidirectional DC/DC converter
104-1 isolated bidirectional DC/DC converter
104-2 isolated bidirectional DC/DC converter
No1 battery
No2 battery
P1 charge pattern
P1A charge pattern
P2 discharge pattern
P2A discharge pattern
P3 differential pattern
P3A differential pattern

## Claims

1. A charge/discharge test system which performs a charge/discharge test on a plurality of charge/discharge targets, comprising:
a bidirectional AC/DC converter that has one end connected to an AC power supply via an AC bus and the other end connected to a first DC bus;
an isolated bidirectional DC/DC converter that has one end connected to the bidirectional AC/DC converter via the first DC bus and the other end connected to a second DC bus;
a plurality of non-isolated bidirectional DC/DC converters that respectively have one ends connected to the isolated bidirectional DC/DC converter via the second DC bus and the other ends connected to charge/discharge targets different from each other; and
a charge/discharge controlling unit configured to control the bidirectional AC/DC converter, the isolated bidirectional DC/DC converter, and the non-isolated bidirectional DC/DC converters, to control charging and discharging of the charge/discharge targets respectively connected to the non-isolated bidirectional DC/DC converters,
wherein the charge/discharge controlling unit charges power output from at least one charge/discharge target to be discharged among the charge/discharge targets via the non-isolated bidirectional DC/DC converter, into at least chargeable one of the charge/discharge targets via the second DC bus and at least one of the non-isolated bidirectional DC/DC converters.

2. The charge/discharge test system according to claim 1, wherein in a case where discharge power that is power discharged from all charge/discharge targets to be discharged is in surplus over necessary charge power that is power necessary to charge all charge/discharge targets to be charged, the charge/discharge controlling unit regeneratively returns surplus power corresponding to a surplus amount of the discharge power from at least one of the non-isolated bidirectional DC/DC converters to the AC power supply via the second DC bus, the isolated bidirectional DC/DC converter, the first DC bus, the bidirectional AC/DC converter and the AC bus.

3. The charge/discharge test system according to claim 1, wherein in a case where discharge power that is power discharged from all charge/discharge targets to be discharged is in shortage below necessary charge power that is power necessary to charge all charge/discharge targets to be charged, the charge/discharge controlling unit charges supplementary power that supplements a shortage amount of the discharge power from the AC power supply into at least one of the charge/discharge targets via the AC bus, the bidirectional AC/DC converter, the first DC bus, the isolated bidirectional DC/DC converter, the second DC bus and at least one of the non-isolated bidirectional DC/DC converters.

4. The charge/discharge test system according to claim 1, comprising
a power pool which is connected to the second DC bus, and configured to be charged and discharged under control by the charge/discharge controlling unit, wherein
in a case where discharge power that is power discharged from all charge/discharge targets to be discharge is in surplus over necessary charge power that is power necessary to charge all charge/discharge targets to be charged, the charge/discharge controlling unit charges surplus power corresponding to a surplus amount of the discharge power from at least one of the non-isolated bidirectional DC/DC converters into the power pool via the second DC bus.

5. The charge/discharge test system according to claim 4, wherein in a case where there is an excess of the surplus power over a chargeable capacity of the power pool, the charge/discharge controlling unit regeneratively returns power corresponding to an excess amount of the surplus power from the second DC bus to the AC power supply via the isolated bidirectional DC/DC converter, the first DC bus, the bidirectional AC/DC converter and the AC bus.

6. The charge/discharge test system according to claim 4, wherein
a plurality of power supply devices respectively including the isolated bidirectional DC/DC converter, the second DC bus, the power pool and the plurality of non-isolated bidirectional DC/DC converters, are connected to the bidirectional AC/DC converter via the first DC bus, and
in a case where there is an excess of the surplus power over a chargeable capacity of the power pool in at least one of the power supply devices, the charge/discharge controlling unit outputs power corresponding to an excess amount of the surplus power in the at least one of the power supply devices, to at least another one of the power supply devices that is capable of receiving input of power, via the first DC bus.

7. The charge/discharge test system according to claim 1, comprising
a power pool which is connected to the second DC bus, and configured to be charged and discharged under control by the charge/discharge controlling unit, wherein
in a case where discharge power that is power discharged from all charge/discharge targets to be discharged is in shortage below necessary charge power that is power necessary to charge all charge/discharge targets to be charged, the charge/discharge controlling unit charges supplementary power that supplements a shortage amount of the discharge power from the power pool into at least one of the charge/discharge targets via the second DC bus and at least one of the non-isolated bidirectional DC/DC converters.

8. The charge/discharge test system according to claim 7, wherein in a case where a dischargeable capacity of the power pool is in shortage below the shortage amount of the discharge power, the charge/discharge controlling unit charges power that supplements a shortage amount of the dischargeable capacity from the AC power supply into at least one of the charge/discharge targets via the AC bus, the bidirectional AC/DC converter, the first DC bus, the isolated bidirectional DC/DC converter, the second DC bus, and at least one of the non-isolated bidirectional DC/DC converters.

9. The charge/discharge test system according to claim 7, wherein
a plurality of power supply devices respectively including the isolated bidirectional DC/DC converter, the second DC bus, the power pool and the plurality of non-isolated bidirectional DC/DC converters, are connected to the bidirectional AC/DC converter via the first DC bus, and
in a case where the dischargeable capacity of the power pool is in shortage below the shortage amount of the discharge power in at least one of the power supply devices, the charge/discharge controlling unit outputs power from at least one of the power supply devices that is capable of outputting power to the at least one of the power supply devices in which the dischargeable capacity is in shortage, via the first DC bus.

10. The charge/discharge test system according to claim 1, wherein
a plurality of power supply devices respectively including the isolated bidirectional DC/DC converter, the second DC bus and the plurality of non-isolated bidirectional DC/DC converters, are connected to the bidirectional AC/DC converter via the first DC bus, and
in a case where power necessary to charge a charge/discharge target is in shortage in at least one of the power supply devices, and at least another one of the power supply devices is capable of power supply to other the power supply devices, the charge/discharge controlling unit executes power supply from the at least another one of the power supply devices capable of power supply to the at least one of the power supply devices in which the power necessary to charge the charge/discharge target is in shortage, via the first DC bus.

11. The charge/discharge test system according to any one of claims 6, 9, and 10, wherein the charge/discharge controlling unit synchronizes timings for the charge/discharge test between the power supply devices different from each other.

12. The charge/discharge test system according to any one of claims 2 to 9, wherein
the charge/discharge controlling unit calculates the necessary charge power based on a result of correction which increases power necessary to charge the all charge/discharge targets to be charged by an amount of power consumed by all non-isolated bidirectional DC/DC converters corresponding to the all of charge/discharge targets to be charged, and
the charge/discharge controlling unit calculates the discharge power based on a result of correction which reduces power discharged from the all charge/discharge targets to be discharged by an amount of power consumed by all non-isolated bidirectional DC/DC converters corresponding to the all charge/discharge targets to be discharged.

13. The charge/discharge test system according to any one of claims 1 to 10, wherein the plurality of non-isolated bidirectional DC/DC converters respectively include:
at least one converter under test, connected to a test charge/discharge target that is a charge/discharge target subjected to the charge/discharge test; and
at least one surplus converter connected to an auxiliary charge/discharge target that is another charge/discharge target other than the test charge/discharge target.

14. The charge/discharge test system according to any one of claims 1 to 10, wherein the charge/discharge controlling unit synchronizes a timing for discharging power from at least one of the charge/discharge targets and a timing for charging power into at least one of the charge/discharge targets.

15. A control method for a charge/discharge test system, the system including
a bidirectional AC/DC converter that has one end connected to an AC power supply via an AC bus and the other end connected to a first DC bus,
an isolated bidirectional DC/DC converter that has one end connected to the bidirectional AC/DC converter via the first DC bus and the other end connected to a second DC bus, and
a plurality of non-isolated bidirectional DC/DC converters that respectively have one ends connected to the isolated bidirectional DC/DC converter via the second DC bus and the other ends connected to charge/discharge targets different from each other,
wherein the bidirectional AC/DC converter, the isolated bidirectional DC/DC converter and the non-isolated bidirectional DC/DC converters, are controlled to control charging and discharging of the charge/discharge targets respectively connected to the non-isolated bidirectional DC/DC converters,
the control method comprising:
charging power output from at least one of the charge/discharge targets to be discharged via the non-isolated bidirectional DC/DC converter, into at least chargeable one of the charge/discharge targets via the second DC bus and at least one of the non-isolated bidirectional DC/DC converters.
